(19) Europäisches Patentamt / European Patent Office / Office européen des brevets

(11) **EP 4 468 219 B1**

(12) **EUROPEAN PATENT SPECIFICATION**

(45) Date of publication and mention of the grant of the patent:
**11.03.2026 Bulletin 2026/11**

(21) Application number: **24177963.6**

(22) Date of filing: **24.05.2024**

(51) International Patent Classification (IPC):
**G06Q 10/0631** *(2023.01)*    **G06Q 10/0637** *(2023.01)*
**G06F 30/13** *(2020.01)*    **G06F 30/20** *(2020.01)*
**G06Q 50/08** *(2012.01)*

(52) Cooperative Patent Classification (CPC):
**G06Q 10/06313; G06F 30/13; G06F 30/20; G06Q 10/06375; G06Q 50/08**

(54) **COMPREHENSIVE OPTIMIZATION SYSTEMS AND METHODS FOR WHOLE LIFECYCLE CARBON MANAGEMENT AND CIRCULARITY PLANNING OF EXISTING AND NEW BUILDINGS THROUGH MULTI-CRITERIA SIMULATIONS AND ANALYSES**

UMFASSENDE OPTIMIERUNGSSYSTEME UND VERFAHREN ZUR GANZLEBENSZYKLUSKOHLENSTOFFVERWALTUNG UND KREISFÖRMIGKEITSPLANUNG BESTEHENDER UND NEUER GEBÄUDE DURCH MULTIKRITERIENSIMULATIONEN UND ANALYSEN

SYSTÈMES ET PROCÉDÉS D'OPTIMISATION COMPLÈTE POUR LA GESTION DU CARBONE DE CYCLE DE VIE ET LA PLANIFICATION DE CIRCULARITE DE BÂTIMENTS EXISTANTS ET NOUVEAUX PAR SIMULATIONS ET ANALYSES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **24.05.2023 US 202363504015 P**

(43) Date of publication of application:
**27.11.2024 Bulletin 2024/48**

(73) Proprietor: **Adaptis Technologies Canada Inc.**
**Toronto, ON M5A 0W4 (CA)**

(72) Inventors:
• **Shahi, Sheida**
  **Toronto, M5V 2Y1 (CA)**
• **Mollaei, Aida**
  **Toronto, M5V 2Y1 (CA)**

(74) Representative: **Dr. Gassner & Partner mbB**
**Wetterkreuz 3**
**91058 Erlangen (DE)**

(56) References cited:
US-A1- 2010 235 206    US-A1- 2013 325 410
US-A1- 2020 380 179    US-A1- 2022 374 802

## Description

## Technical Field

The embodiments disclosed herein relate to building projects and, in particular, to systems and methods for optimization of multiple objectives for new constructions and existing building adaptations.

## Introduction

Adaptation of existing buildings has increased in recent years as a means to preserve said buildings while responding to changing environmental conditions and current requirements for energy use and production of waste, and as an alternative to demolition and/or new construction. In general, buildings have a permanency ranging from 50-75 years and, without adaptation, obsolescence and demolition are inevitable. Various jurisdictions have created goals for future energy use which can only be met by adaptation of existing buildings. For example, Canada has committed to reducing energy use in all buildings by forty percent and overall GHG emissions in existing buildings by eighty percent by 2050. US 2010/235206 A1 describes a system that relates to modular buildings, and more specifically to smart or multifunctional panels and methods, systems and computer program products for designing, optimizing and constructing modular buildings. US 2020/380179 A1 describes a system that deals with building material estimates for the construction of a building and environmental impacts. US 2013/325410 A1 describes a system for construction of objects such as buildings, comprises computer processor that applies pre-defined build formulas or formula relationships for structure elements based on support data, and generates object construction plan. US 2022/374802 A1 describes a system for architecture and building design and specifically relates to a method of analyzing a CAD model to quantify total embodied environmental impact.

Current methodologies for optimizing adaptation of existing buildings only optimize a limited number of metrics for a limited number of design options which are pre-generated before said metrics are considered. Furthermore, even with the limited number of metrics for the pre-generated designs the process can take on the order of months and is still not likely to generate the most optimal design as neither the limited pre-generated designs nor the limited optimization metrics are comprehensive.

Additionally, current methodologies for new construction designs do not consider how the building may need to be adapted in the future.

Currently, construction accounts for fifty percent of annual material consumption globally and sixty percent of waste generation in the economy. Re-use and recycling of construction materials only occurs for thirty percent of the waste generated.

Accordingly, there is a need for improved multi-objective methodologies which can create comprehensive building adaptation designs quickly while concurrently providing optimization analysis for said designs to both improve the quality of building adaptations and expedite the process. Such methodologies may also consider the environmental vs. the financial costs of any demolition or deconstruction which may occur during adaptation.

## Summary

Provided herein is a method of building project circularity optimization comprising selecting a plurality of building strategies from a list of building strategies, inputting building information including an initial building geometry, generating a building model using the at least one selected building strategy and the building information, generating simulations of a plurality of design scenarios based on the building model, analyzing the plurality of design scenarios for a plurality of building metrics to determine at least one optimal design scenario by: analyzing the plurality of design scenarios by multi-objective optimization methods, analyzing the salvage estimation of the design scenarios by: calculating recoverable building materials of the design scenarios by: inputting building materials, generating material takeoff, generating cost, value, and environmental impact datasets, and generating a precedence matrix, performing an optimization wherein: a first salvage objective is optimized and a second salvage objective is calculated, the second salvage objective is optimized and a first salvage objective is calculated, and a project first salvage objective-second salvage objective tradeoff curve is generated, analyzing each building material for end of life (EoL) possibilities using the optimization, performing a sensitivity analysis to validate the EoL possibilities and to analyze an optimization framework, finally, and outputting a circularity and salvage potential for the at least one optimal design scenario.

The design scenarios may include modular designs and the method may further comprise parametrizing the building information into a plurality of building parameters, inputting building requirements, developing design constraints based on the building parameters, the building requirements, and the building model by creating a grid of the initial building geometry, determining possible module characteristics, determining parameters of module assemblies, and determining and correcting any spatial adjacencies, wherein generating simulations of a plurality of design scenarios further includes generating simulations of a plurality of design scenarios from an algorithm developed using the building information, the building requirements, the design constraints, and the building model.

The initial building geometry may be one of a geometry of an existing building and a geometry of a future building.

The plurality of building strategies may include at least two of restructuring, recladding, insulating, relocating, layering, extending glazing, enclosing, adding, insetting, and extending.

The first salvage objective may be time and the second salvage objective may be cost.

Generating simulations of each design scenario may include simulating energy use and daylighting of each scenario.

The method may further comprise calculating a life cycle analysis and a life cycle costing for each assembly determined during development of the design constraints. Calculating a total life cycle analysis and life cycle costing for each design scenario may include the life cycle analyses and life cycles costings for each assembly.

The method may further comprise setting performance constraints and filtering design scenarios using the performance constraints.

The at least one optimal design scenario may be selected based on life cycle costing and structural complexity.

Pareto-optimal results may be generated.

The method may further comprise analyzing the design scenarios against previously analyzed buildings or external building databases.

Provided herein is a system for building project circularity optimization, the system comprising at least one processor, and a non-transitory storage medium, storing processor executable instructions, wherein the at least one processor executes the instructions to select a plurality of building strategies from a list of building strategies, input building information including an initial building geometry, generate a building model using the at least one selected building strategy and the building information, generate simulations of a plurality of design scenarios based on the building model, analyze the plurality of design scenarios to determine at least one optimal design scenario by: analyzing the plurality of design scenarios by multi-objective optimization methods, analyzing the salvage estimation of the design scenarios by: calculating recoverable building materials of the design scenarios by: inputting building materials, generating material takeoff, generating cost, value, and environmental impact datasets, and generating a precedence matrix, performing an optimization wherein: a first salvage objective is optimized and a second salvage objective is calculated, the second salvage objective is optimized and a first salvage objective is calculated, a project first salvage objective-second salvage objective tradeoff curve is generated, analyzing each building material for end of life (EoL) possibilities using the optimization, perform a sensitivity analysis to validate the EoL possibilities and to analyze an optimization framework, and output a circularity and salvage potential for the at least one optimal design scenario.

The design scenarios of the system may include modular designs and the at least one processor further executes the instructions to parametrize the building information into a plurality of building parameters, input building requirements, develop design constraints based on the building parameters, the building requirements, and the building model by: create a grid of the initial building geometry, determine possible module characteristics, determine parameters of module assemblies, and determine and correcting any spatial adjacencies, wherein generating simulations of a plurality of design scenarios further includes generating simulations of a plurality of design scenarios from an algorithm developed using the building information, the building requirements, the design constraints, and the building model.

Provided herein is a method of salvage estimation for a building project, the method comprising calculating recoverable building materials of a building of interest by inputting building materials, generating material takeoff, generating cost, value, and environmental impact datasets and generating a precedence matrix, performing an optimization wherein: a first salvage objective is optimized and a second salvage objective is calculated, the second salvage objective is optimized and the first salvage objective is calculated, and a project first salvage objective-second salvage objective tradeoff curve is generated, analyzing each building material for end of life (EoL) possibilities using the optimization, and performing a sensitivity analysis to validate the EoL possibilities and to analyze an optimization framework.

The sensitivity analysis may be chosen from a group consisting of: a Monte Carlo analysis, a One at a Time (OAT) analysis, an All Combinations analysis, and a Future Scenario analysis.

The first salvage objective may be time and the second salvage objective may be cost.

The EoL possibilities may include: demolition and disposal, demolition, sorting and recycling, and deconstruction and reuse.

Provided herein is a system for salvage estimation for a building project, the system comprising at least one processor and a non-transitory storage medium, storing processor executable instructions, wherein the at least one processor executes the instructions to calculate recoverable building materials of the building of interest by: inputting building materials, generating material takeoff, generating cost, value, and environmental impact datasets, and generating a precedence matrix, perform an optimization wherein: a first salvage objective is optimized and a second salvage objective is calculated, the second salvage objective is optimized and the first salvage objective is calculated, and a project first salvage objective-second salvage objective tradeoff curve is generated, analyze each building material for end of life (EoL) possibilities using the optimization, and perform a sensitivity analysis to validate the EoL possibilities and to analyze an optimization framework.

The sensitivity analysis may be chosen from a group consisting of: a Monte Carlo analysis, a One at a Time (OAT) analysis, an All Combinations analysis, and a Future Scenario analysis.

Other aspects and features will become apparent to those ordinarily skilled in the art, upon review of the following description of some exemplary embodiments.

## Brief Description of the Drawings

The drawings included herewith are for illustrating various examples of articles, methods, and apparatuses of the present specification. In the drawings:

Figure 1 is a flow diagram of a conventional methodology for building adaptation.

Figure 2A is a flow diagram overview of a methodology for building adaptation using physics-based simulation tools and decision-making tools, such as, interactive multi-objective optimization, including three stages, according to one embodiment.

Figure 2B is a flow diagram of the first stage of the methodology for building adaptation using physics-based simulation tools and interactive multi-objective optimization of Figure 2A, comprising building design scenario selection and model preparation, according to one embodiment.

Figure 2C is a flow diagram of the second stage of the methodology for building adaptation using physics-based simulation tools and interactive multi-objective optimization of Figure 2A, comprising design scenario simulation, according to one embodiment.

Figure 2D is a flow diagram overview of the third stage of the methodology for building adaptation using physics-based simulation tools, multi-attribute utility, and interactive multi-objective optimization of Figure 2A, comprising result analysis, according to one embodiment.

Figure 3 is multiple perspective views of an existing building system wherein each view shows a different type of adaptation which could be used to adapt the existing building, and which may be considered in the methodology of Figures 2A-2D, according to one embodiment.

Figure 4 is a line graph wherein each line represents the effect of each different type of adaptation from Figure 3 on various metrics of the methodology of Figures 2A-2D, according to one embodiment.

Figure 5 is multiple line graphs wherein each line represents a rank for the effect of each different type of adaptation from Figure 3 on various metrics of the methodology of Figures 2A-2D wherein the various metrics have been variably weighted, according to one embodiment.

Figure 6A is a flow diagram overview of a methodology for generating modular design scenarios for building adaptations involving extension of an existing building wherein the methodology includes three stages, according to one embodiment.

Figure 6B is a flow diagram of the first stage of the methodology for generating modular design scenarios, of Figure 6A, comprising analysis and parametrization of the existing building, according to one embodiment.

Figure 6C is a flow diagram of the second stage of the methodology for generating modular design scenarios, of Figure 6A, comprising option generation and simulation in real-time, according to one embodiment.

Figure 6D is a flow diagram of the third stage of the methodology for generating modular design scenarios, of Figure 6A, comprising result refinement and optimization, according to one embodiment.

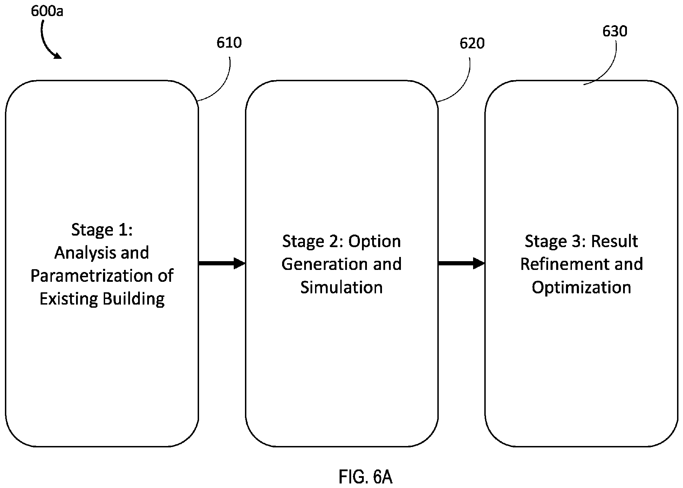

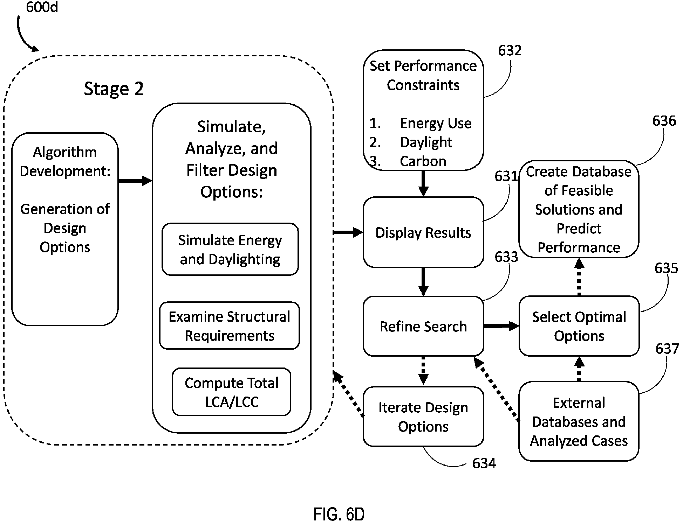

Figure 6D is a flow diagram of steps in the methodology for generating modular design scenarios of Figure 6A, according to one embodiment.

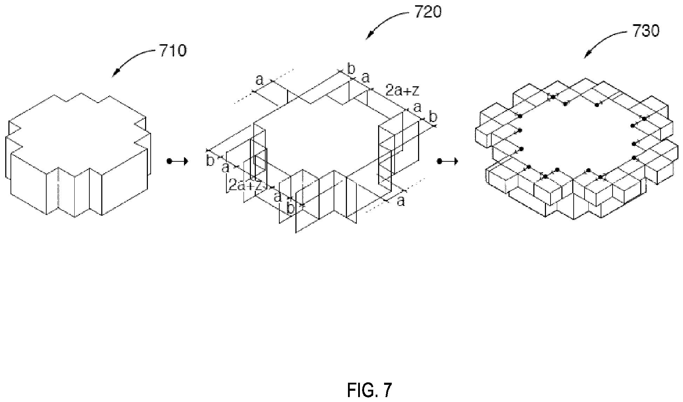

Figure 7 is a view of existing building analysis according to the methodology of Figures 6A-D, according to one embodiment.

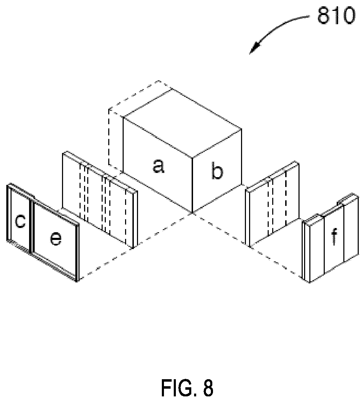

Figure 8 is a view of module and panel parametrization according to the methodology of Figures 6A-D, according to one embodiment.

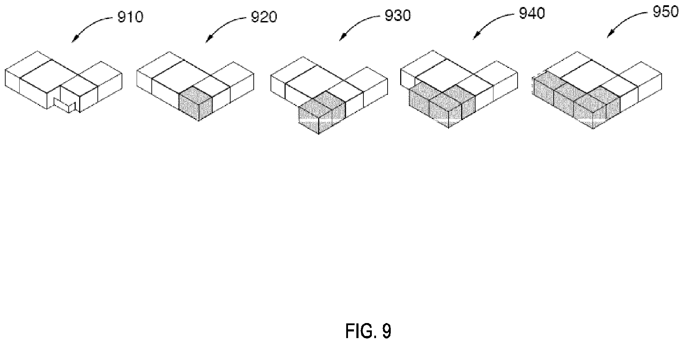

Figure 9 is a view of possible unit growth patterns according to the methodology of Figures 6A-D, according to one embodiment.

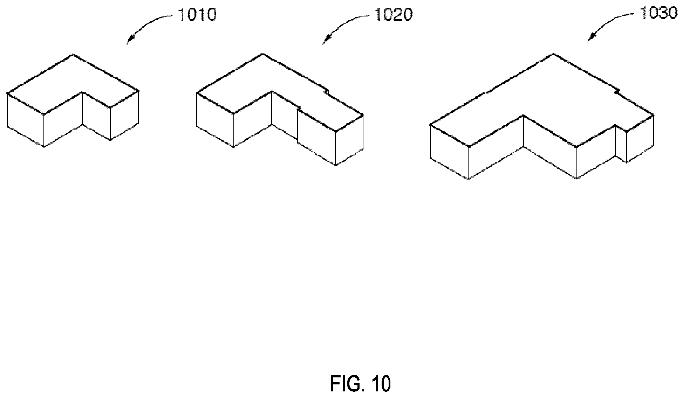

Figure 10 is a view of examples of extension of an apartment unit according to the methodology of Figures 6A-D, according to one embodiment.

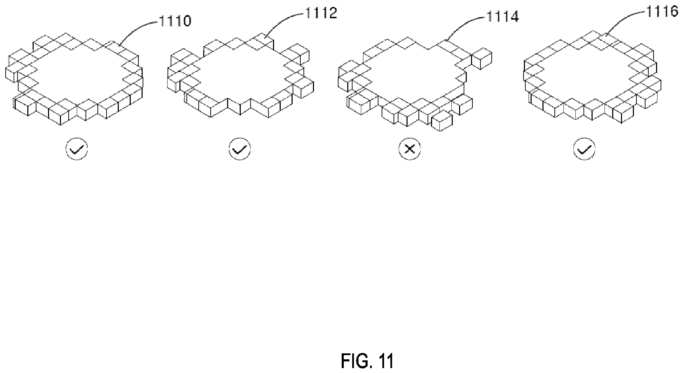

Figure 11 is a view of combinations of various extensions for an existing building according to the methodology of Figures 6A-D, according to one embodiment.

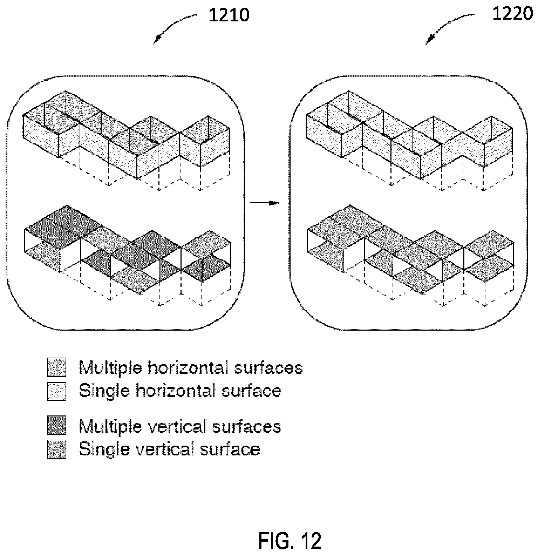

Figure 12 is a view of how adjacencies are solved according to the methodology of Figures 6A-D, according to one embodiment.

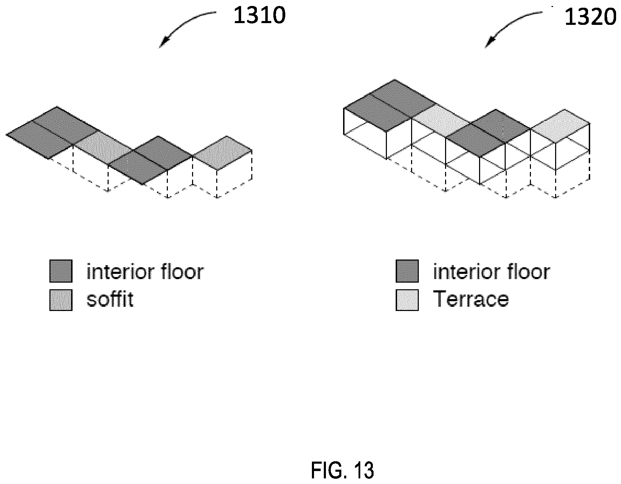

Figure 13 is a view of material assignment for extended units in an existing building according to the methodology of Figures 6A-D, according to one embodiment.

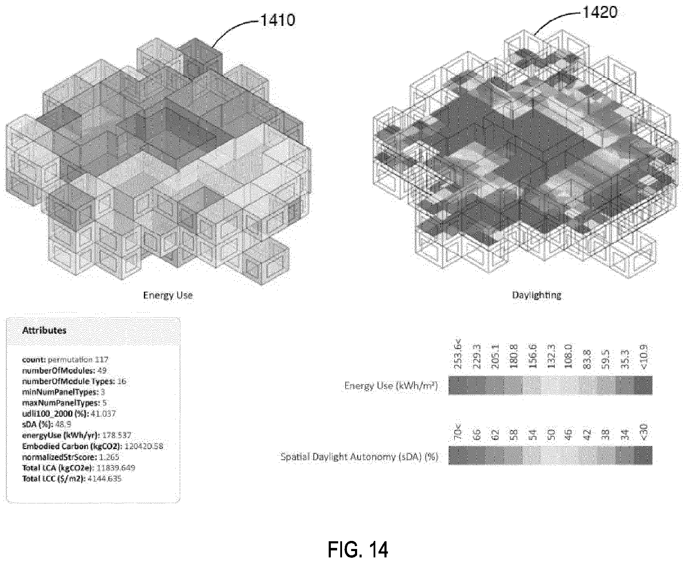

Figure 14 is a view of a design combination from the methodology of Figures 6A-D showing the effect of the design combination on energy use and daylighting, according to one embodiment.

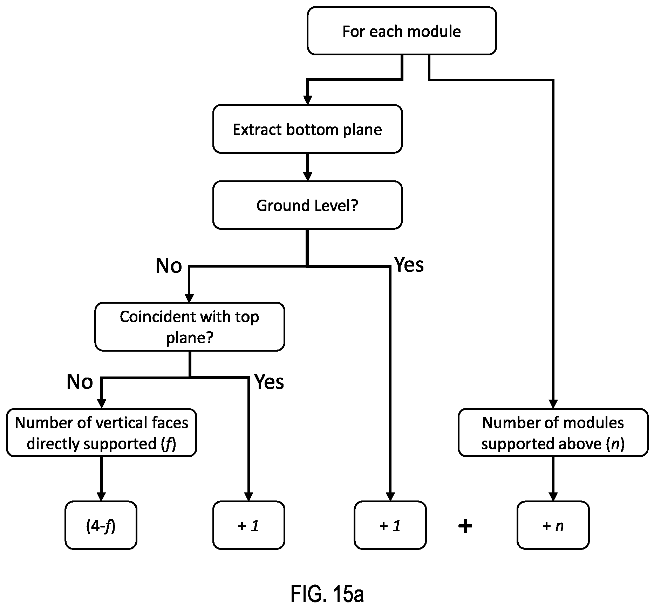

Figure 15A is a workflow for calculating the structural complexity of a design according to the methodology of Figures 6A-D, according to one embodiment.

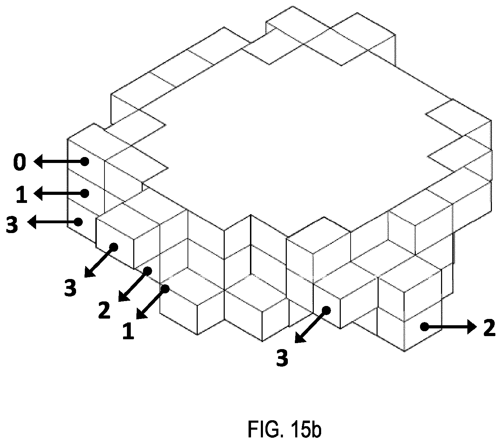

Figure 15B is a view showing sample structural complexity scores of a design combination according to the workflow of Figure 15A, according to one embodiment.

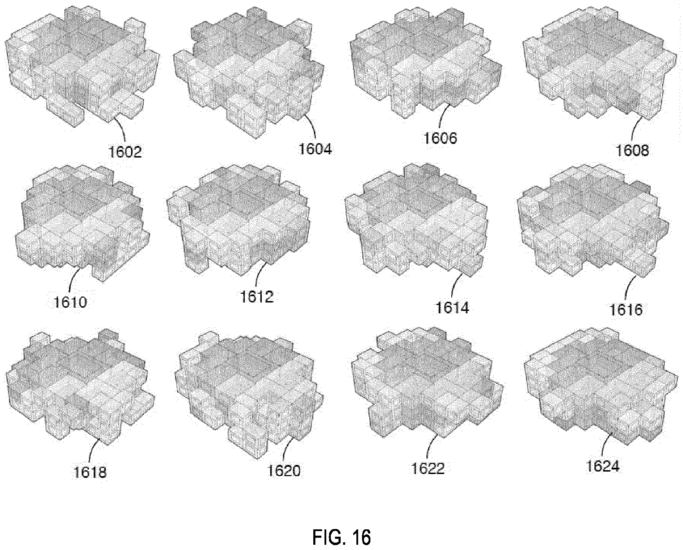

Figure 16 is multiple views showing pareto-optimal design permutations according to the methodology of Figures 6A-D, according to one embodiment.

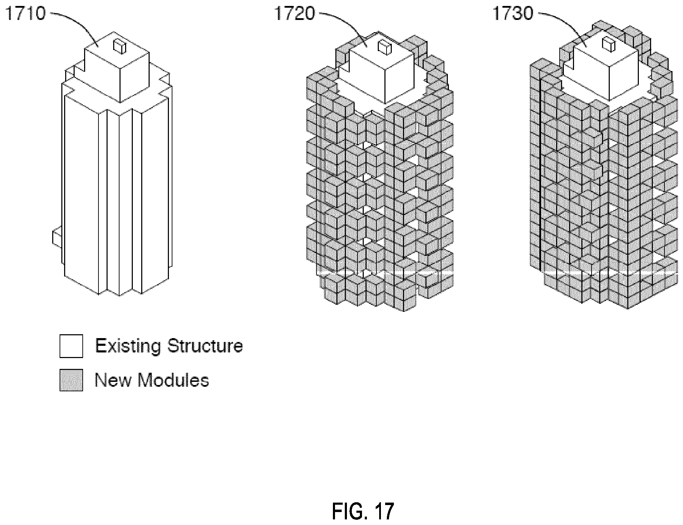

Figure 17 is multiple views of an existing building and design permutations of the entire building according to the methodology of Figures 6A-D, according to one embodiment.

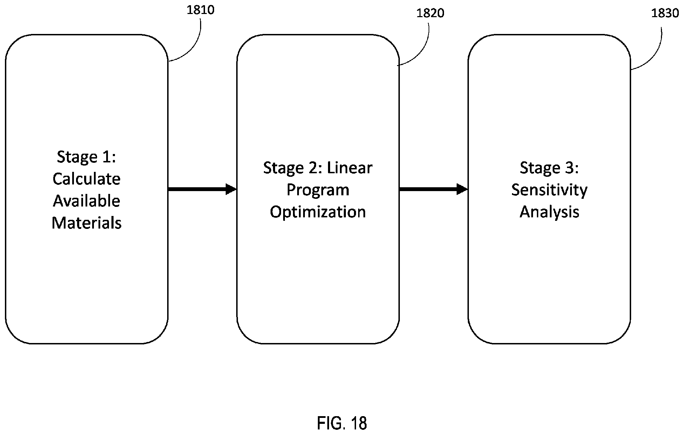

Figure 18 is a flow diagram overview of a methodology for in-situ building material value estimation for an existing building, according to one embodiment.

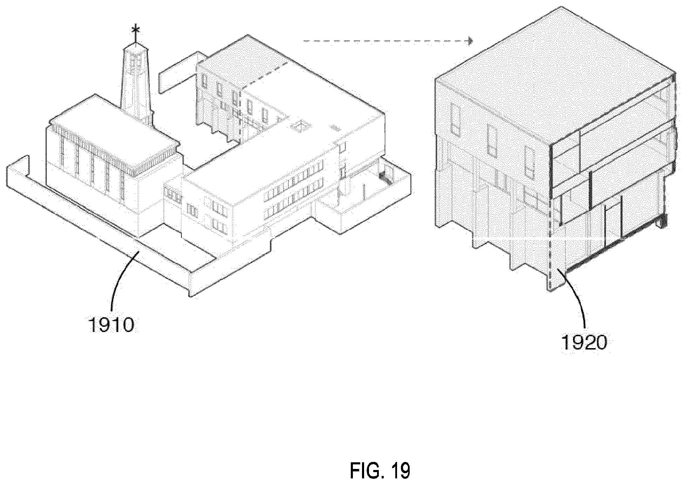

Figure 19 is a view of an example of a case study existing building to which the methodology of Figure 18 is applied, according to one embodiment.

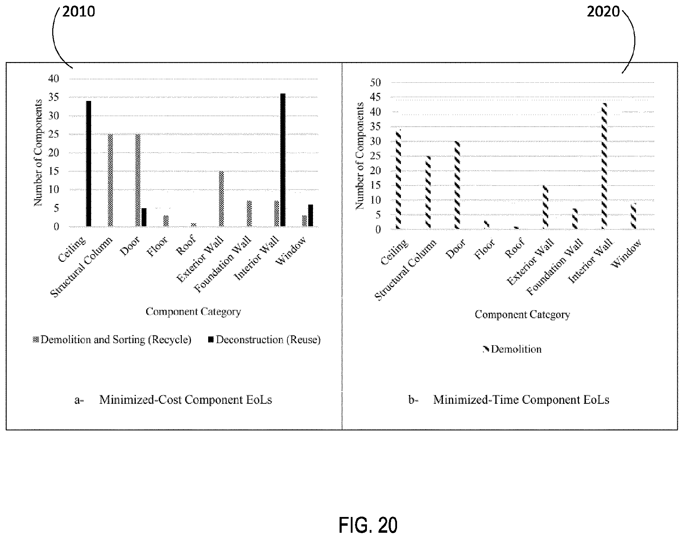

Figure 20 shows example graphs representing component end-of-lifes for a cost optimized scenario and a time optimized scenario according to the methodology of Figure 18, according to one embodiment.

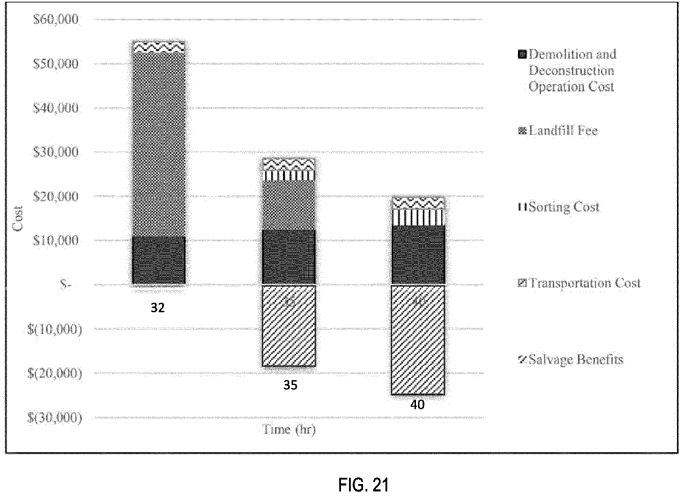

Figure 21 shows an example graph representing the cost breakdown as it varies by project duration according to the methodology of Figure 18, according to one embodiment.

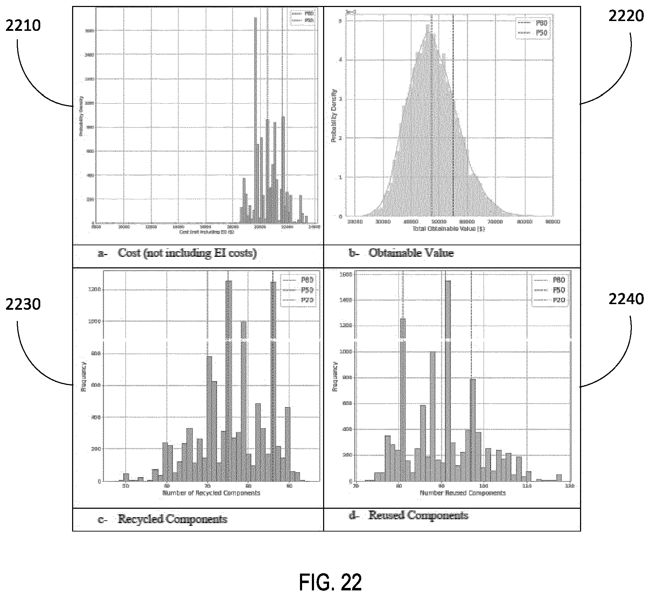

Figure 22 shows example graphs representing future scenario analysis results according to the methodology of Figure 18, according to one embodiment.

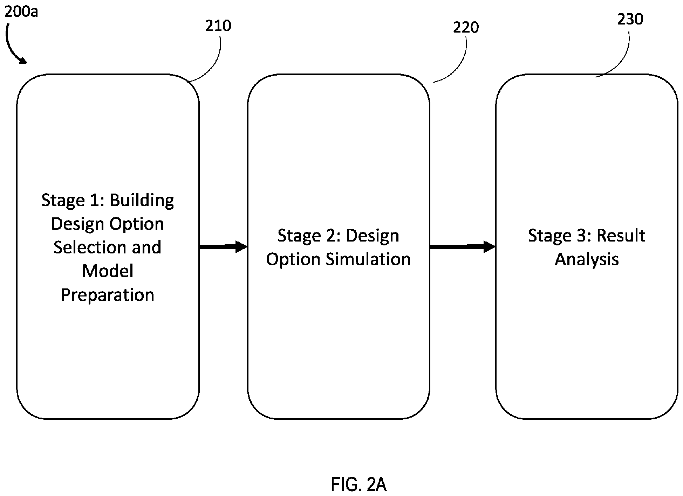

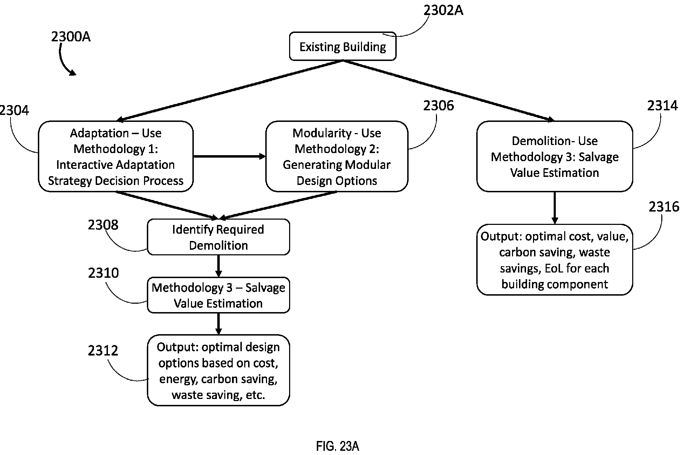

Figure 23A is a flow diagram overview of a comprehensive methodology for building adaptation of an existing building which includes the methodologies of Figures 2A-2D, Figures 6A-6D, and Figure 18, according to one embodiment.

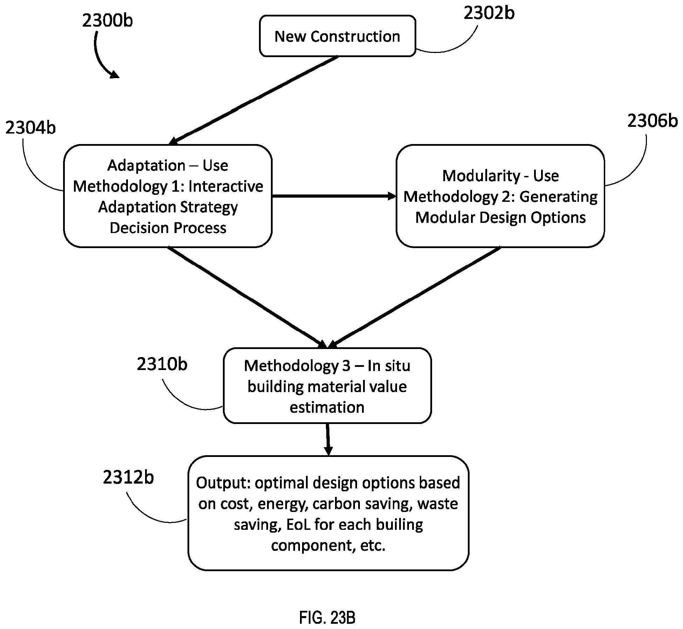

Figure 23B is a flow diagram overview of a comprehensive methodology for a new building project which includes the methodologies of Figures 2A-2D, Figures 6A-6D, and Figure 18, according to one embodiment.

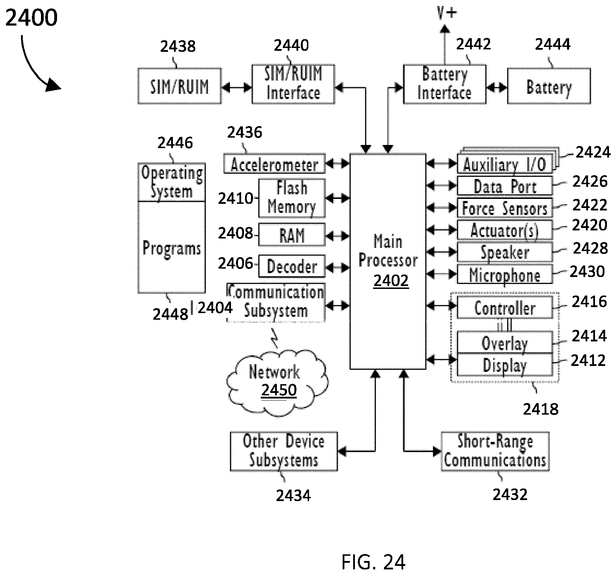

Figure 24 is a block diagram of a computing device for executing the methods herein.

## Detailed Description

Various apparatuses or processes will be described below to provide an example of each claimed embodiment. No embodiment described below limits any claimed embodiment and any claimed embodiment may cover processes or apparatuses that differ from those described below. The claimed embodiments are not limited to apparatuses or processes having all of the features of any one apparatus or process described below or to features common to multiple or all of the apparatuses described below.

Three different methodologies for adaptation of existing buildings which are marked improvements over current and conventional methodologies are discussed below as well as a comprehensive methodology which incorporates at least two of the methodologies and where desired all three methodologies.

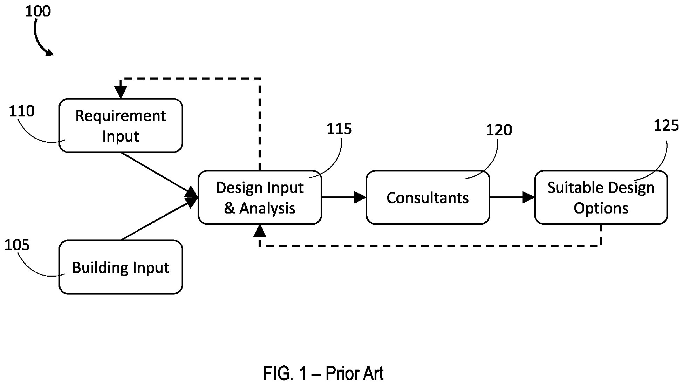

Referring to Figure. 1, illustrated therein is a conventional method 100 for building adaptation.

Conventional methods, as discussed above, require generation of designs prior to determining which of the pre-generated designs is the best when considering various metrics and the importance of said metrics to the various stakeholders involved in the adaptation of the building.

In Figure 1, the process begins both with building input 105 wherein the current attributes of the building are considered and input into the workflow and with requirement input 110 wherein the various requirements for the adaptation of the building are considered and input into the workflow. Building input 105 may include any factors such as dimensions, materials, environment, areas for improvement, condition, etc., which are relevant to the existing building and to adaptation. Requirement input 110 may include any factors such as government or other policies regarding construction (e.g., energy use, landfill use, etc.), time constraints, cost constraints, daylighting, etc.

Next, design input and analysis 115 is performed wherein building input 105 and requirement input 110 are taken into account to create design scenarios which fit the requirements for the adaptation. These designs are often few in number and are preliminary and exploratory design scenarios developed by a design team which are then analyzed by various consultants 120 for various factors (i.e., energy consultants consult on energy use, life cycle analysis consultants consult on the life cycle of the designs, etc.) to determine which of the preliminary designs are suitable design scenarios 125 for adaptability due to meeting the minimum requirements set out at the beginning of the process. If no suitable design scenarios are found, or it is thought that the design could be improved, then the method must return to the design input and analysis 115 to create further design scenarios to be reviewed by consultants.

Most analysis methodologies used in the method of Figure 1 analyze one or a few metrics at a time and therefore may require several rounds of design and consultation before a suitable design scenario can be found. Even if a suitable design scenario is found relatively quickly, the process takes months and is limited to the design scenarios generated by the design team and to the stepwise, asynchronous workflow of design, then consult, then review, and repeat as appropriate.

It can be summarized that in most studies proposing methodologies, a limited number of design strategies are considered, and there is a lack of methodologies that consider a comprehensive range of design strategies and analyzes them simultaneously using physics-based simulation algorithms and multi-objective decision-making methods.

The systems and methodologies described below solve many of the issues associated with the current, conventional methods as described above in Figure 1.

While herein adaptation of existing buildings is shown in most of the figures and is the primary example discussed, the methodologies can also be applied when designing new construction projects. Future recovery of building components is directly a result of the decisions made at the design stage and the processes that take place during the construction phase. Learning from the value that efficient urban mining of existing buildings can provide in circulating building materials back into the economy, has led to a need to consider the end of life of building components even in the initial stages of the building life cycle. The comprehensive quantitative methodologies discussed herein can generate optimal circular design and construction strategy options considering the technical feasibility of implementation, financial limitations, future market value of salvage materials, and environmental impacts associated with each strategy.

The three design methodologies discussed below represent i) a methodology using integrated physics-based simulation tools and decision-making tools in a design process enabling a user to determine optimal designs through interactive multi-objective analysis, ii) a methodology for an interactive design process of generating modular design scenarios for building projects and iii) a methodology for in-situ building material value estimation of an existing building or a new construction. All three design methodologies include algorithms for automated generation of scenarios, eliminating the need for the scenarios to be pre-generated by a designer/architect, as well as allowing for vastly more scenarios to be analyzed, ultimately resulting in higher chance for improved decarbonization and greater optimization. With these methodologies, decision makers or other stakeholders can be confident that they have the most optimal design scenarios and not just the most optimal scenario of a small subset of possible scenarios.

Materials used in buildings contain embodied carbon as a result of the raw material extraction, production, and transportation processes that led to the use of the material in the building. The materials also have an impact on the operational carbon emission of the building. An assessment of the impact of various materials on both the operational and embodied carbon leads to an optimal decarbonization strategy.

In any of the methodologies, machine learning algorithms may be used to streamline the process of automated generation of scenarios. That is, as more building adaptation projects are completed, the algorithms may "learn" that certain options do not need to be simulated as they will never be the optimal scenario. Machine learning would make the process more efficient.

Referring now to Figure 2A, therein is illustrated an overview of a methodology 200a for integrating physics-based simulation tools and decision-making tools into a design process which enables optimized assessment of building adaptation design scenarios. The methodology 200a enables computer-based design of building adaptations which considers the effects of various building adaptation design strategies on multiple environmental and economic objectives simultaneously to determine which building adaptation strategy is optimal. The methodology 200a herein shows the effects of only a single building adaptation strategy, however multiple building adaptation strategies may be employed simultaneously, and the effects of multiple adaptation strategies may be determined for the various objectives. Methodology 200a enables at least one decision maker to interactively evaluate the environmental and/or economic feasibility of an adaptation project. Herein, adaptation projects for existing buildings are discussed but the effects of a particular adaptation on the design of a new construction could also be achieved by methodology 200a. The methodology 200a could also be used to contemplate adaptations which could be performed in the future on a new construction to aid in the planning of the entire "life" of the building.

The methodology 200a is a computer based methodology wherein at least one decision maker (stakeholder in the adaptation of the building) can perform the methodology on a computing device with a user interface for viewing the various stages of the methodology, and an input mechanism for inputting and adjusting the various requirements of the process.

Decision-making tools employed in methodology 200a may include multi-attribute utility analysis (MAU) and/or interactive multi-objective optimization (IMO), among other tools.

Eight performance metric objectives are discussed herein for methodology 200a, but more or less metrics could be employed. The eight performance metrics discussed are energy use, thermal comfort, daylighting, natural ventilation, systems performance, life cycle, cost-benefit, and constructability.

Methodology 200a uses a physics-based simulation for design scenarios. Physics-based design scenarios have conventionally been difficult for designers to use or understand and traditionally do not provide immediate access to design feedback or comparison metrics. Therefore, conventional processes using physics-based simulation are time consuming and may not result in the optimal design. Methodology 200a allows for the use of physics-based simulation of design scenarios in an automated manner which enables for simultaneous analysis of multiple design scenarios and better optimization of building adaptation quickly because each design is parametrized.

In the embodiment of Figures 2A-2D, ten building adaptation strategies, eight performance metrics, and four orientations are considered for a total of 12,800 simulations to determine how the adaptation strategies would perform for an existing building. The methodology can be used to create an initial interactive indexing tool that can be quickly applied to similar buildings. The methodology increases both the efficiency and accuracy of design scenarios which can be presented to decision makers. As well, if any preferences for the adaptation of the building change, the design scenarios have already been generated for the majority of possible scenarios.

Stage 1 of methodology 200a is building design scenario selection and model preparation 210.

Stage 2 of methodology 200a is design scenario simulation 220.

Stage 3 of methodology 200a is result analysis 230.

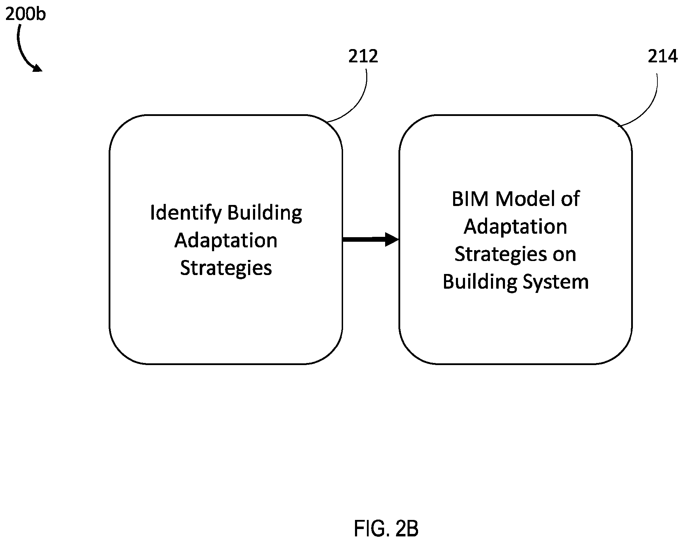

Figure 2B is a flow diagram 200b of stage 1 of Figure 2A.

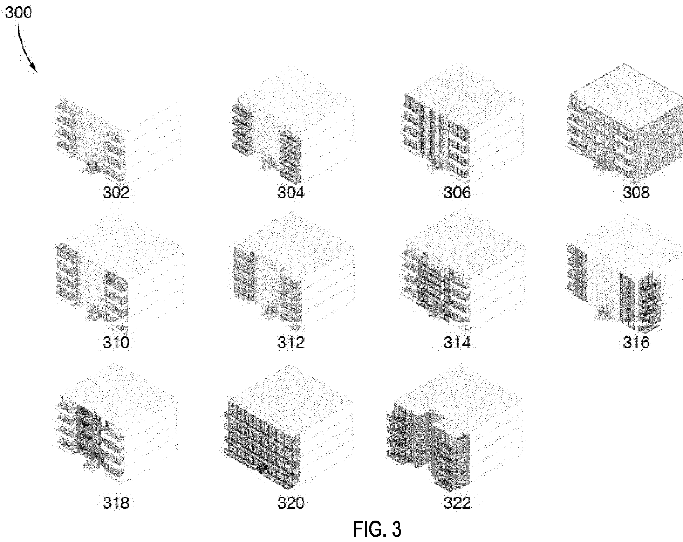

The first step 212 of stage 1 is to identify building adaptation strategies. The ten building adaptation strategies employed in the embodiment of Figures 2A-5, as shown in Figure 3, are restructuring, extending glazing, recladding, enclosing, insulating, adding, relocating, insetting, layering, and extending. Depending on the specific building some of these strategies may not apply or different strategies may apply. The user may select as many or as few adaptation strategies as they like. Limiting the strategies to only those considered to be most likely may decrease the amount of time to complete the methodology but if the identification of the strategies is incorrect then the actual optimal design may be missed.

The second step 214 of stage 1 is to prepare a building information modeling (BIM) model using the identified adaptation strategies to the building system to be adapted. The BIM model may be developed by a system like Revit ® and may include information regarding such factors as construction length, cost, and life cycle phasing.

In other embodiments the model may be any building model and not necessarily a building information model. That is, a BIM is used herein as an example of a building model which could be employed.

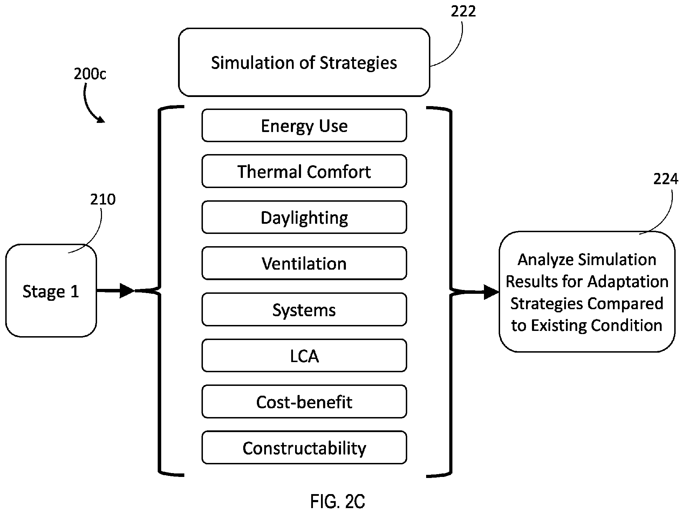

Figure 2C is a flow diagram 200c of stage 2 of Figure 2A.

The first step 222 of stage 2 is to generate simulations of the identified strategies using the BIM model prepared during stage 1 at step 214. The second step 224 of stage 2 is to analyze the generated simulations to compare the adaptation strategies to the existing building and to each other. In the embodiment of Figures 2A-5, as discussed above, the eight metrics used for the simulations are energy use, thermal comfort, daylighting, ventilation, systems performance, life cycle analysis, cost-benefit, and constructability. In other embodiments, more, less, or different metrics may be used. Various physics-based simulation tools, for example those employed with Revit® or Rhino® Grasshopper® are used to measure the eight metrics. Selected tools may include Sefaira® for energy use, daylighting and systems simulation, Honeybee® for thermal comfort, Autodesk CFD® for natural ventilation, One-Click LCA® for life cycle analysis, Sigma Estimates® for costing and the Sustainability ROI Workbook for cost-benefit analysis and scheduling tools in Revit®.

Figure 2D is a flow diagram 200d of stage 3 of Figure 2A. At stage 3 the results of stage 2 are analyzed. That is, the generated simulations of adaptation strategies from step 222 of Figure 2C and the various calculated metrics associated with each simulation from step 224 of Figure 2C are further analyzed to find an optimal adaptation strategy.

The steps of stage 3 include a multi-attribute utility analysis (MAU) 232, an interactive multi-objective optimization (IMO) analysis 234, and a sensitivity analysis 236.

The multi-attribute utility analysis step 232 is an analysis of alternatives, wherein in this methodology the alternatives are the various adaptation strategies which have been generated. The MAU analysis 232 requires that each of the eight metrics be assigned a weight. The weights may merely be assigned or a determination of weight factor distribution may be performed for each of the metrics being analyzed. In one embodiment, a single utility function may be determined (between 0 and 1) to determine the weight and importance of each metric. Multiple scenarios in which different metrics have different weights may be analyzed simultaneously.

In one embodiment the MAU for a design scenario x is:

$$v\left(x\right) = \sum_{i=1}^{n} w_i v_i(x_i)$$

where $v_i x_i$ is the value of design scenario x on the $i_{th}$ attribute, $w_i$ is the importance weight of the $i_{th}$ attribute and is a constant for each iteration, and n is the number of different attributes.

The interactive multi-objective optimization analysis step 234 allows a decision maker to interact with the analysis to achieve a Pareto optimal solution. Because a large number of design scenarios have been automatically generated the decision maker can be confident that they are seeing the majority of possible design scenarios. The decision maker receives preliminary feedback regarding the simulated adaptation strategies, in this case from the MAU analysis 232, and then can alter the preferences or make other changes to the overall design scenario to arrive at a preferable solution. Because the process is interactive the decision maker is able to learn about the relationships between the various strategies and metrics to make informed decisions.

In one embodiment, the IMO analysis 234 is performed in stages or steps wherein the decision maker only changes one or a few preferences at a time to enable a better understanding of the effects of each parameter.

In this embodiment, the IMO analysis 234 allows the decision maker to alter preferences by a value on a scalar function, and use weighted metrics to find the Pareto optimal solution(s). Within this methodology, the optimal solution is determined by the decision maker and may not be the actual objective optimal solution. In one embodiment, the decision maker's optimal solution is calculated as:

$$y\left(x\right) = \sum_{i=1}^{n} vw_i y_i(x_i)$$

where $y_i x_i$ is the value of design scenario x on the $i_{th}$ attribute, $vw_i$ is the varied importance weight of the $i_{th}$ attribute, and n is the number of different attributes.

The IMO analysis interface may incorporate sliders as a means for the decision maker (or one of a plurality of decision makers) to alter the value of $vw_i$.

In order to ensure that the methodology of Figure 2A-2D is robust, a sensitivity analysis was performed in the testing of the methodology. Each parameter is expected to have a variable and individual impact on the variation of the percentage of change when determining optimal design strategies for a given building. For example, size, complexity, and distribution of strategies within a building are expected to have the highest impact on the percentage of change.

A sensitivity analysis may be used to identify which of the metrics are the most reliable for determining an optimal design. Each time the methodology is used on a new building or on a building which is known to be more complex or sufficiently different from any buildings the methodology has been previously employed on, the decision maker(s) may wish to perform sensitivity analysis to be confident in the results of the MAU and IMO analyses. Where the building is known to be similar to a building which has previously employed the methodology, or where the decision maker(s) is confident in which metrics are most important, the decision maker(s) may choose not to do a sensitivity analysis.

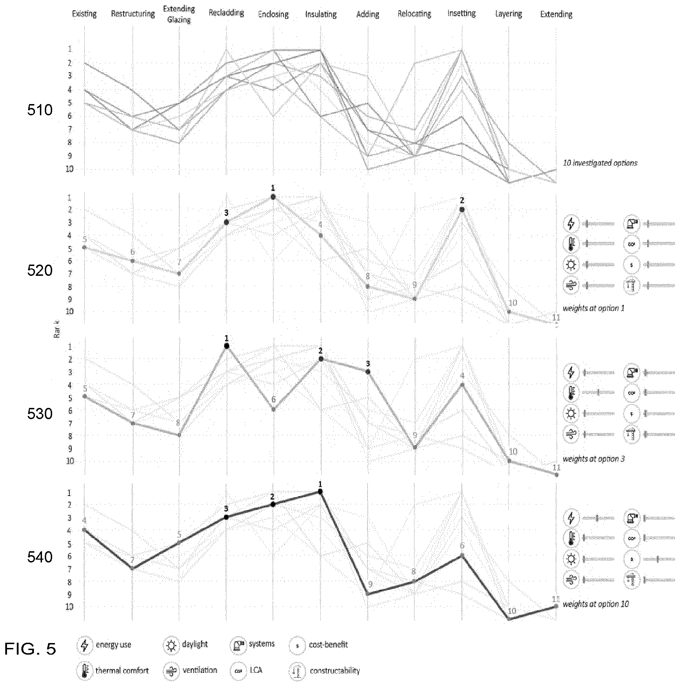

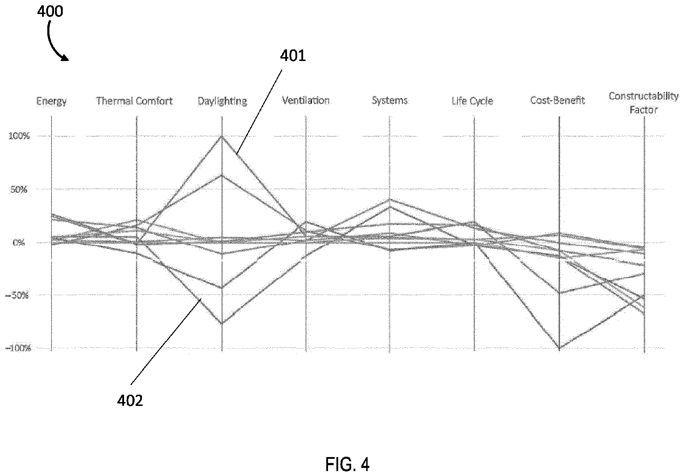

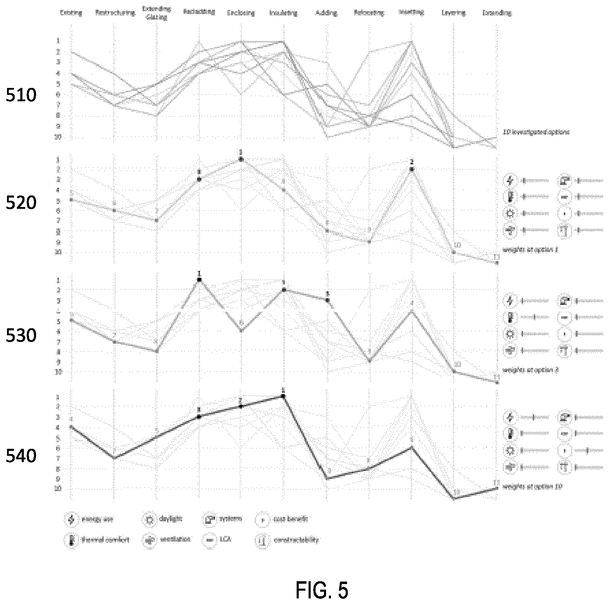

Figure 3 is multiple perspective views of an existing building system wherein each view shows a different type of adaptation which could be used to adapt the existing building, and which may be considered in the methodology of Figures 2A-2D. The existing building system 302 shows a building with balconies on a front side of the building. Building 304 shows a building employing the adaptation strategy of balcony restructuring. Building 306 shows a building employing the adaptation strategy of extending glazing. Building 308 shows a building employing the adaptation strategy of recladding. Building 310 shows a building employing the adaptation strategy of enclosing. Building 312 shows a building employing the adaptation strategy of insulating. Building 314 shows a building employing the adaptation strategy of insulating. Building 316 shows a building employing the adaptation strategy of adding. Building 318 shows a building employing the adaptation strategy of relocating. Building 320 shows a building employing the adaptation strategy of insetting. Building 322 shows a building employing the adaptation strategy of layering. Building 324 shows a building employing the adaptation strategy of extending. The embodiment of the methodology of Figures 2A-2D discussed herein and shown in Figures 4 and 5 looks at employing only one adaptation strategy at a time but the methodology could also be applied to design scenarios which employ more than one adaptation strategy (where possible).

Each of the ten adaptation strategies are simulated to acquire results for the effects on the eight metrics discussed above. Results are shown in Figure 4 and discussed below.

Figure 4 is a line graph 400 wherein each line represents the effect of each different type of adaptation from Figure 3 on various metrics of the methodology of Figures 2A-2D.

Each line of the graph represents an adaptation strategy wherein the percentage of change relative to the existing building for each of the eight metrics is shown for each adaptation strategy at a vertical line representing the metric.

For example, insetting (line 401) provides the greatest percentage of change for daylighting of around 100% while layering (line 402) would cause a roughly 75% decrease in daylighting.

Graph 400 represents the raw results for each metric for each adaptation strategy and does not provide information regarding which adaptation may be optimal based on the wants or needs of the decision maker and the overall benefits of each adaptation when viewing the metrics together and not separately.

Figure 5 is multiple line graphs 510, 520, 530, and 540 wherein each line in each line graph represents a rank for the effect of each different type of adaptation from Figure 3 on various metrics of the methodology of Figures 2A-2D at one of ten varying weight scenarios for the metrics. Figure 5 represents the results of a MAU analysis as described above.

Figure 5 represents an interface that may be shown to the decision maker(s) to enable the decision maker to search through all of the data and see the effects of the different weight scenarios for the adaptation strategies. The interface may also allow the decision maker(s) to perform IMO analysis by changing the weights of the metrics.

Line graphs 510, 520, 530, and 540 include eleven vertical lines each representing either the existing building or one of the ten adaptation strategies shown in Figure 3. Each graph 510, 520, 530, and 540 includes ten horizontal lines representing a ranking of each adaptation from 1-10 for the effects of the adaptation on the overall percentage of change.

Graph 510 shows all ten investigated weight scenarios for the eight metrics (energy use, thermal comfort, daylighting, ventilation, systems performance, life cycle analysis, cost-benefit, and constructability) with each line representing a weight scenario.

Graph 520 specifically shows the rankings for the existing building and the ten adaptation strategies for a first weighted scenario wherein all of the metrics are weight equally. The existing building is ranked fifth, while enclosing, insetting, and recladding are first through third, respectively.

Graph 530 shows a second weighted scenario wherein thermal comfort is weighted more highly than the other seven metrics which are rated equally. The existing building is ranked fifth, while recladding, insulating, and adding are ranked first through third, respectively.

Graph 540 shows a third weighted scenario wherein energy use and cost-benefit are equally weighted more highly than the other six metrics which are also equally rated. The existing building is ranked fourth, while insulating, enclosing, and recladding are ranked first through third.

In some embodiments of the methodology of Figures 2A-5, the decision maker may choose to only perform IMO analysis on a limited number of adaptation strategies. That is, after MAU analysis it may be clear that some of the adaptation strategies are not feasible while others are. Therefore, the decision maker may choose to only perform IMO analysis for the highest-performing adaptation strategies.

In some embodiments of the methodology of Figures 2A-5, the decision maker may choose to perform IMO analysis with a limited number of metrics. That is, after MAU analysis it may be clear that none of the adaptation strategies result in improvement for some of the metrics and further analysis of those metrics will not provide useful information. Additionally, if a sensitivity analysis has been performed the decision maker may choose to only use the metrics which are the most reliable.

The methodology of Figures 2A-5 makes decision-making accessible to decision makers at early stages of the process of building adaptation instead of requiring months of design and consultation which cannot occur simultaneously, and which may require multiple rounds of design and/or consultation. Additional methodologies which improve upon current conventional methodologies are discussed below and may work in concert with the methodology of Figures 2A-5.

Figures 6A-D represent a methodology for generating modular design scenarios for building adaptation. The methodology can be used for various types of adaptation (e.g., extension, recladding, glazing, insulating, etc.) and for both new construction and adaptation of existing buildings. However, herein, the methodology is shown and discussed for extension of an existing building. This methodology can also be applied to generate design scenarios which will enable a new build to be adapted in the future. That is, the methodology may anticipate what adaptations the building may require in the future, for example in twenty to thirty years, and generate design scenarios for the initial build which will allow the building to be adapted easily in twenty to thirty years. This methodology can be applied for instances wherein the adaptation strategy for the existing building includes employing modular construction (MC). MC is used in building adaptation as a means to increase efficiency for design, production, and construction (adaptation). MC allows for multiple cycles of use for the modules and materials, resulting in lower life cycle costs and life cycle impacts. MC is also often more energy-efficient. However, the usefulness of the modules and materials can only be realized if the appropriate adaptation strategy is chosen.

Compared to traditionally constructed concrete buildings, prefabricated MC can reduce environmental impacts, lead to economic benefits with increased on-site productivity and construction quality, improve predictability regarding lifecycle costs, energy performance and environmental impact, acoustic quality, airtightness, and thermal performance. Designing buildings for reuse using modular construction, instead of recycling at End-of-Life (EoL), can also reduce life cycle impacts by 88%, and facilitates maintenance, repair, and reuse during different life cycle stages of a building, minimizing waste generation during construction and deconstruction. Prefabrication of modular components in controlled factory environments can reduce construction waste by 10-15% on average. Lifecycle greenhouse gas emissions over a 50-year life of a modular building are calculated to be lower on average compared to typical construction.

The methodology of Figures 6A-6D can be employed for a multitude of metrics including but not limited to the metrics employed in the methodology of Figure 2A-5.

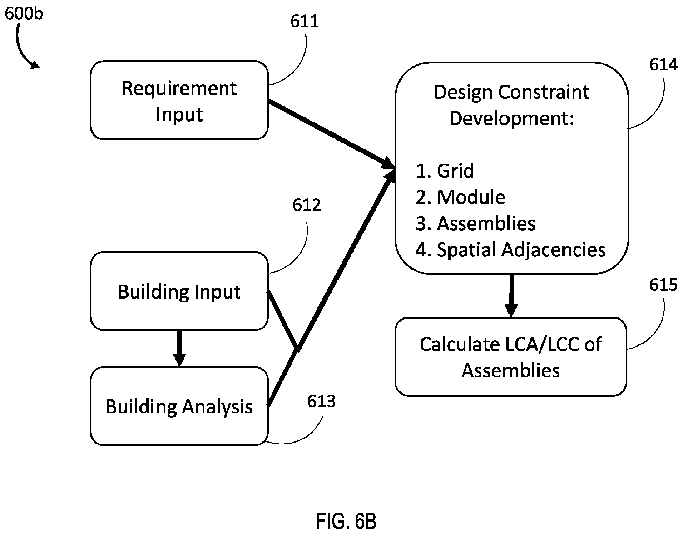

Figure 6A is a flow diagram overview of a methodology 600a for generating modular design scenarios for building adaptations involving extension of an existing building wherein the methodology includes three stages. The methodology of Figure 6A is further discussed in Figures 6B-6D and an example of using the methodology is discussed in Figures 7-17.

The methodology of Figures 6A-17 can be employed following the methodology of Figures 2A-5 if extension is found to be a feasible adaptation strategy or if it is known that extension of the building will be chosen for adaptation then the methodology of Figure 2A-5 can be skipped and just the methodology of Figures 6A-17 can be performed. As discussed above, extension of an existing building is intended as an example of the methodology, and the methodology of Figure 6A-17 can also be applied to new construction and to adaptations other than extension.

The methodology 600a is a computer based methodology wherein a decision maker(s) can perform the methodology on a computing device with a user interface for viewing the various stages of the methodology, and an input mechanism for inputting and adjusting the various requirements of the process.

Stage 1 includes analysis and parametrization 610 of the existing building.

Stage 2 includes option generation and simulation 620.

Stage 3 includes result refinement and optimization.

Figure 6B is a flow diagram of the first stage 600b of the methodology for generating modular design scenarios, of Figure 6A, comprising analysis and parametrization of the existing building.

At step 611, the requirements for the modular extension of the building are input into the methodology. The requirements may include factors such as budget, timeline, spatial requirements, performance benchmarks, material requirements, any local construction policies that need to be met, etc. The requirement input is used as an input when generating design scenarios.

At step 612, the characteristics of the building are input. At step 613 the input building characteristics are analyzed and parametrized. The building characteristics which are input include at least building geometry. An analysis of the building is used as an input when generating design scenarios. The geometry of the existing building is modelled including both the interior spaces and the building envelope. Desired design parameters are determined based on any structural, environmental, and/or spatial shortcomings of the building. The building is modelled as zones and aggregated into topological complexes. The building is also discretized into panels and other elements.

Steps 611 and 612/613 could be performed in any order or simultaneously.

At step 614, the inputs from step 611 and steps 612/613 are used for design constraint development. Design constraint development includes creating a speculative grid for the existing building which can be used to modular design, determining the possible characteristics of module, determining parameters for assembly of modules, and determining and correcting spatial adjacencies. To create the grid, the building geometry from the building input is analyzed dimensionally and spatially for extension and dimensions of a module are determined. For example, in an embodiment where the adaptation strategy may include extension and recladding steps for design constraint development may include i) generating building parameters to define modular extension parameters, generating module parameters with spatial configurations, and generating connection parameters, growth patterns, and restrictions, ii) generating panel parameters including the dimensions of panels, spatial organization of panels, and panel connection details, and iii) generating rules and patterns for unit growth by testing spatial layouts using modules and panel types and defining module and panel combinations for each existing unit type.

At step 615, a Life Cycle Analysis (LCA) is performed and Life Cycle Costing (LCC) is determined for the various assemblies. First, the LCA of the existing building is determined using the existing operational energy use standards. Second, after the modules and panels are determined at step 614, an LCA for the building with modules is determined. An algorithm for determining the LCA and LCC of actual design scenarios which will be generated at Stage 2 is created from the base LCA for the modules determined at step 614. The LCA must be calculated using the appropriate environmental standards for the jurisdiction. The user (e.g., designer, modeler, client, etc.) can input various preferences and constraints and review the results to then reconfigure priorities in real-time as the project occurs. The user can create input parameters for option generation from this interactive process. The building analysis results and the created input parameters are used at stage 2 to generate the design scenarios.

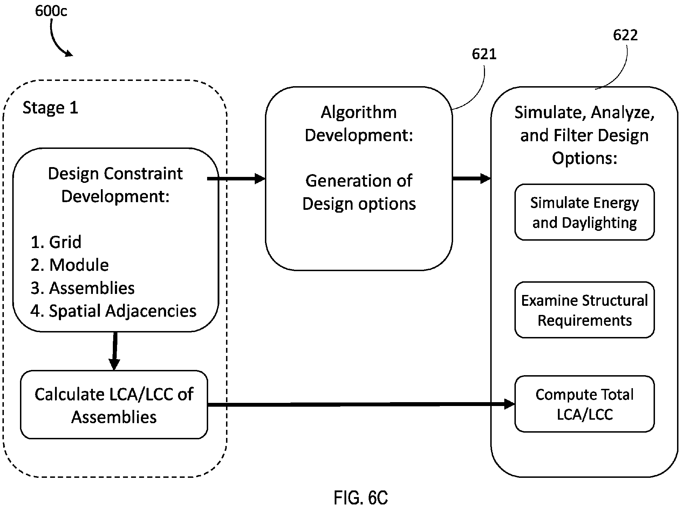

Figure 6C is a flow diagram of the second stage of the methodology for generating modular design scenarios, of Figure 6A, comprising option generation and simulation in real-time.

At step 621, a design algorithm is generated from the building analysis results and input parameters which were created in stage 1. The algorithm allows for automatic generation of an extension design scenario by positioning modules based on the information stored in the grid which was created in stage 1. Over 600 designs can be generated and analyzed in just two weeks.

Design scenarios may be generated using a tool such as Topologic® within a program like Grasshopper® or other generative design tools.

The existing geometry of the building is modelled as b-reps (boundary representation schema) either as a new model or on existing drawings of the building. The b-reps are used as input in a module translating program such as Rhino® which organizes the b-reps and forms topologic complexes. Design scenarios are generated through a heuristic-guided exhaustive search with the number of options being finite and relatively small to allow for computation and comparison of all the possible options. Invalid options are eliminated.

Adjacencies wherein there are multiple alignments of horizontal or vertical surfaces must be solved by eliminating the multiple surfaces to create a single alignment.

A defined assembly must be set for every surface so that metrics such as energy use, daylighting, and Spatial Daylight Autonomy (sDA) can be properly computed.

For each design combination, the number of modules, panel types, extension area, and other characteristics must be accurately extracted from the model to ensure that the metrics are calculated accurately and different design scenarios can be compared.

At step 622, the design scenarios are simulated, analyzed, and filtered.

The energy use of each design scenario is calculated in real-time. Energy use may be calculated by the Grasshopper® program using the Honeybee® plugin.

Daylighting is also simulated for each design scenario.

An evaluation of the structural complexity of each module is also performed. A structural complexity score provides an indication of which materials would be used for each module and the module connections and ensures that the design is feasible structurally, financially, and from a life cycle perspective. The structural complexity score may be used when calculating the LCA and LCC of the design scenarios.

As each design scenario is generated the LCA and LLC are calculated in real-time. The LCA for the existing building was previously calculated during stage 1 and can be used as a comparison for each design scenario. The LCA for the design scenarios also considers the extension of life for the building once adapted.

Figure 6D is a flow diagram of the third stage of the methodology for generating modular design scenarios, of Figure 6A, comprising result refinement and optimization.

At step 631, the results of stage 2 are presented on a user interface to a user(s).

At step 632, the user can set performance constraints to filter out design scenarios which are not preferred. Performance constraints may include energy use, daylighting, embodied carbon, the number of modules, structural complexity score, LCA, and/or LCC. Other constraints may be used in other embodiments.

At step 633, the search is refined by the performance constraints and the user is shown filtered design scenarios.

At step 634, if the user is not satisfied with the results the process can return to stage 2 to iterate on the generated and simulated design scenarios.

At step 635, the user can select optimal design scenarios or optimal design scenarios may be automatically selected. The optimal design scenarios may be selected based on comparison LCC and structural complexity. Pareto-optimal results may be presented for further analysis.

At step 636, information from previously analyzed buildings or other external databases may be input and used to refine the search or to select optimal options from a refined search. That is, the methodology may use available information from previously studied or adapted buildings to improve the generation or selection of optimal design scenarios.

At step 637, the user may create a database of feasible solutions and may use other means to further predict the performance of those feasible design scenarios. A database may also be automatically created for the user.

Figures 7-17 show the application of the methodology of Figures 6A-6D to an example building.

Figure 7 is a view of existing building analysis according to the methodology of Figures 6A-D for an example building.

Drawing 710 is a representation of part of the existing building being analyzed in the example. The first three storeys of the building are represented.

Drawing 720 is a representation of the building geometry discretized into panels and elements as well as speculative grid options for the example building. The speculative grid options show possible locations, connections, and dimensions of module extensions. A grid option is chosen from the speculative grid options and the dimensions of the modules are defined based on the grid option. In drawing 720 the grid is determined as derivatives of a, b, and z.

Drawing 730 shows placement of modules with growth dimensions, direction (arrows), and starting points (black dots) determined based on the module size for the chosen grid options and on the interior layout of the building (not shown). Connection parameters and growth restrictions are also considered at this stage of the methodology.

Figure 8 is a view of module and panel parametrization according to the methodology of Figures 6A-D.

Drawing 810 shows a module with panels a and b, with blown out panels of the module shown with different joining condition requirements of the panels being labelled as c, e, and f, wherein c represents a connection of two modules together, e represents attachment of a module to the existing building, and f represents an exterior façade. The possible module configurations and therefore the number of panel divisions for panels a and b are determined for each joining condition c, e, and f.

Various configurations of panels with joining conditions c, e, and f as well as various configurations of modules having the different configurations of panels may be designed and considered.

Figure 9 is a view of possible unit growth patterns according to the methodology of Figures 6A-D. Rules and patterns for unit growth are determined by testing spatial layouts of units using module and panel types and then defining combinations of modules and panels for each existing unit type.

Drawing 910 represents the existing unit layout as well as blocks which show areas into which the unit cannot extend.

Drawings 920, 930, 940, and 950 represent various modular extensions to the existing unit which one, two, three, and four modules being added, respectively (grey sections). The possible extensions for each unit are at the defined module size. The user can determine unit growth patterns (e.g., how many modules are added and where) by texting the spatial layouts for each existing unit and defining combinations of possible extensions with the knowledge of which panel types could be used for each unit. Assembly types of the modules could include connecting module floor, exposed floor, exposed roof, exterior wall (solid), exterior wall (glazing), recladding, or connecting interior module wall. As each assembly is generated the LCA and LCC are also calculated for use in stage 2 of the methodology.

Figure 10 is a view of examples of extension of an apartment unit according to the methodology of Figures 6A-D. Figure 10 represents the first step of Stage 2 for the methodology applied to the example building. Possible design combinations are generated based off of the input from stage 1 and any design scenarios which do not meet requirements are eliminated.

Drawing 1010 represents a bachelor unit of the existing example building. Drawing 1020 represents extension of the bachelor unit into a 1-bedroom unit. Drawing 1030 represents extension of the bachelor unit into a bachelor unit and a 1-bedroom unit which does not align with set spatial requirements and is eliminated as a possible design scenario.

Figure 11 is a view of combinations of various extensions for an existing building according to the methodology of Figures 6A-D. Figure 10 showed possible extensions for a single unit while Figure 11 shows extensions for an entire floor of the example building.

Based on the design parameters generated during stage 1 of the methodology, all possible design combinations are generated. As in Figure 10, any design scenarios which do not meet set spatial requirements (or other set requirements) are eliminated.

Figure 11 includes ten design combinations 1110, 1112, 1114, and 1116. Design 1114, while meeting the design parameters, does not meet the set spatial requirements and is therefore eliminated (represented by x).

Figure 12 is a view of how adjacencies are solved according to the methodology of Figures 6A-D. Adjacencies occur when there are multiple vertical or horizontal surfaces in the same location within the generated design. For example, where a vertical wall of a first module is adjacent to a vertical wall of the existing building or to a vertical wall of a second module, or where a floor of a first module is adjacent to a ceiling of an existing unit or a ceiling of a second module below the first module.

Drawing 1210 shows a portion of the extension to the second floor with darker rectangles representing multiple coplanar horizontal or vertical surfaces and lighter rectangles representing locations where there is just one surface. Drawing 1220 shows the same portion of the extension of the second floor where the adjacencies have been removed and each surface represents a single alignment.

Figure 13 is a view of material assignment for extended units in an existing building according to the methodology of Figures 6A-. Material assignment is important for calculating a structural complexity score. Drawings 1310, and 1320 represent the same portion of the extension of the second floor as shown in Figure 12.

Drawing 1310 shows the floor assemblies of the modules in the extension. Darker rectangles represent interior floor materials and lighter rectangles represent soffit materials.

Drawing 1320 shows the roof assemblies of the modules in the extension with darker rectangles representing interior floor materials (which are the same as roof materials when a module is between other modules above and below) and lighter rectangles representing terrace materials.

Drawings would also be created for the wall assemblies in the extension.

The assignment of the material is done for every surface. Assigning the correct materials for the assemblies allows for simulation and calculation of energy use and daylighting as well as LCA and LCC as well as the structural complexity score.

Figure 14 is a view of a design combination from the methodology of Figures 6A-D showing the effect of the design combination on energy use and daylighting as a heat map. Analysis of a single design combination is shown.

Drawings 1410 and 1420 show the same three storeys as drawing 1210 of Figure 12. The drawings both show heat maps wherein red is higher energy use of higher daylighting and blue is lower energy use or lower daylighting. Energy use is calculated as kWh/yr/m$^2$ and daylighting is calculated as spatial daylighting autonomy sDA (the percentage of yearly occupied time with minimum illuminance threshold reach by daylight).

Figure 15A is a workflow for calculating the structural complexity of a design according to the methodology of Figures 6A-D.

The workflow is performed for each module of the design. First, the bottom plane of the module is extracted and queried as to whether the bottom plane is at ground level.

If the bottom plane is at ground level a value of (+1) is added to the structural complexity score.

If the bottom plane is not at ground level it is queried whether the bottom plane is coincident with a top plane (i.e., not at the top of a stack).

If the bottom plane is coincident with a top plane then (+1) is added to the structural complexity score.

If the bottom plane is not coincident with a top plane then a value of (4-f) is added to the structural complexity score, wherein f is the number of vertical faces directly support by the bottom plane.

As well, for each module the number of modules which are above the given module and therefore supported to the module, represented by n, is added (+n) to the structural complexity score.

Figure 15B is a view showing sample structural complexity scores of a design combination according to the workflow of Figure 15A. Figure 15B represents the same three storeys of the example building as drawing 1210 of Figure 12 and the drawings of Figure 14. The structural complexity score of several modules are shown and indicated by an arrow. The scores range from 0 to 3. In other embodiments, the scores may go as high as the design allows.

Figure 16 is multiple views showing pareto-optimal design permutations according to the methodology of Figures 6A-D. Each design of Figure 16 shows the same three storeys as in Figures 12, 14, and 15B but with different modular design scenarios. Twelve design permutations, 1602, 1604, 1606, 1608, 1610, 1612, 1614, 1616, 1618, 1620, 1622, and 1624 are shown.

Permutations 1602, 1604, 1606, 1608, 1610, 1612, 1614, and 1616 represent pareto-optimal options while 1618, 1620, 1622, and 1624 represent secondary options which are the next closest to optimal.

Before pareto-optimal analysis the user may define or re-define the set performance constraints for the design scenarios or may go back and iterate on the design scenarios by altering requirements in stage 2.

The pareto-optimal designs of Figure 16 are optimal for LCC and structural complexity.

Figure 17 is multiple views of an existing building and design permutations of the entire building according to the methodology of Figures 6A-D. Drawing 1710 shows the existing building.

Drawings 1720 and 1730show what the entire building would look like in one of the pareto-optimal design scenarios or secondary design scenarios were applied to the entire building. The design scenarios are optimal for LCC and structural complexity.

In the example of the use of the methodology of Figure 6A-D shown in Figure 7-17 the option generation algorithm was limited to three storeys due to computational limits. In other embodiments, more than three storeys may be computed or less than three storeys based on the complexity of the building and/or the available computational power.

The methodology of Figure 18 (and discussed further in Figures 19-22) enables decision maker(s) to determine either i) if demolition and recovery of available materials is a better financial (or environmental) option than adaptation, i.e., salvage estimation, or ii) what an optimal adaptation design scenario is when considering the value of materials that could be recovered for each design scenario. The methodology can be applied to an existing building, discussed in Figures 18-23A, or to a new building project, discussed in Figure 23B.

Important factors in making a decision regarding recovery of materials during complete demolition or partial demolition for adaptation include building characteristics, operational characteristics, finances, environmental impact, and jurisdictional policies. Building characteristics may include deterioration of materials, age, life spans, geometry of structure, design specifications, and/or building component connections. Operational factors may include end-of-life (EoL) options and/or technology used in recovery. Financial factors may include cost of labour, cost of transport, landfill fees, market value of virgin materials, and/or market value of secondary materials. Environmental factors may include environmental impacts and cost of said impacts, and/or embodied material impacts. Policy factors may include government policies and incentives, carbon taxes, and/or climate action incentives.

Figure 18 is a flow diagram overview of a methodology 1800 for in-situ building material value estimation during adaptation of an existing building, according to one embodiment. This methodology can be employed following one or both of the methodologies discussed above in Figures 2A-5 and Figures 6A-17. During adaptation of an existing building with any of the possible adaptation strategies some demolition of parts of the existing building may be appropriate.

Methodology 1800 provides a framework which combines all of the above factors, and any other relevant factors not listed, with a decision-making tool so that decision makers can make informed choices quickly. Briefly, methodology 1800 includes i) inputting existing building materials, ii) generating material takeoff (quantity, type, location, connections), iii) generating cost, value, environmental impact (EI) datasets to input into a model based on available databases, iv) generating precedence matrix (a matrix that shows how building components are connected and is used for modeling the sequence logic of component extraction in a demolition or deconstruction project), v) running linear program optimization to optimize cost, vi) outputting results indicating what needs to be done with each component of the building.

Methodology 1800 includes three stages 1810, 1820, and 1830.

At Stage 1 1810, the materials which are available for recovery are calculated. Recovery can either be recycling of materials or reuse of materials. A recoverability factor is calculated by equation 1:

$$RF_i = f_i \times (1 - e^{t-\alpha_i} - \frac{t}{10\alpha_i}$$

and a recoverable mass of material is calculated by equation 2:

$$M_{recoverable,i} = M_i \times RF_i$$

wherein $i$ is the component index, $t$ is the age of the building (years), $\alpha_i$ is the life expectancy of the material in component $i$ (years), $f_i$ is an adjustment factor for component $i$ ranging from 0 to 1 (unitless), $M_{recoverable,i}$ is the mass of material that has the potential to be recovered in component $i$ (kg), and $M_i$ is the total mass of the material in component $i$ (kg). The bracketed expression of the recoverability factor calculation is a deterioration model to determine what portion of a given material could still be recovered. The adjustment factor $f$ is used to account for difficulties of material extraction which are predicted to occur as extraction of all available material is rarely, if ever, technically feasible.

At Stage 2 1820, linear program optimization is performed. A multi-objective mixed-integer linear programming (MILP) optimization model is used. The objective functions of the model are to minimize time and to minimize costs. In other embodiments other objectives may be used. To find the optimal solution first cost is optimized and then time associated with the cost-optimal scenario is calculated, and then time is optimized and the cost associated with the time-optimal scenario is calculated. Using the constraint method (Revelle and Whitlach, 1996) in the cost-optimal scenario time constraints are set to the minimum time which was calculated in the time-optimal scenario and the minimum costs under the time constraints are calculated. Then a project time-cost tradeoff curve can be generated.

In other embodiments, an optimization other than linear program optimization may be performed.

In the optimization model each building component has three EoL possibilities: i) demolition and disposal (no salvage value), ii) demolition, sorting, and recycling (scrap value), and iii) deconstruction and reuse (salvage value). In other embodiments, alternative EoL options may be included. The optimization model is designed to show which EoL should be used for each building component while also considering that events must occur in a particular sequence and that different EoL will affect the total project duration differently.

A cost objective function, to minimize the net costs of material extraction based on material quantities, costs of extractions, cost of environmental impact (EI), recoverable material, and terminal values, is calculated by equation 3:

$$NetCost = \sum_{E=1}^{3} \sum_{i=1}^{n} X_{i,E} \left[ (C_{i,E} + EI_{i,E}).M_i - V_{i,E}.M_{recoverable,i} \right]$$

A time objective function, to minimize the total duration of the project, is calculated as:

$$TotalTime = T$$

The indices, parameters, and decision variables used are in the table below.

| Category | Notation | Description |
|---|---|---|
| Indices | $i,j$ | Component Index, $i.j=\{1,2,...,n\}$ ( $n$ is the total number of components) |
| | $E$ | Extraction Method Index, $E=\{1,2,3\}$ (1 is demolition and disposal, 2 is recycling, 3 is reuse) |
| Sets | $A$ | Contains pairs ($i,j$) of window indices ($i$) and their supporting exterior walls ($j$) |
| | $B$ | Contains pairs ($i,j$) of floor indices ($i$) and their supporting exterior walls ($j$) |
| Parameters | $M_i$ | Quantity of material in component $i$ |
| | $C_{i,E}$ | Cost of extraction method $E$ for component $i$ per unit of material |
| | $EI_{i,E}$ | Cost of EI of extraction method $E$ for component $i$ per unit of material |
| | $V_{i,E}$ | Value of component $i$ in extraction method $E$ per unit of mass |
| | $M_{recoverable,i}$ | Quantity of recoverable material per component $i$ |
| | $D_{i,E}$ | Duration of activity $i$ corresponding to extraction method $E$ for component $i$ |
| | $p_{i,j,E}$ | Array-of-precedences matrix in extraction method $E$ |
| | $N$ | Total number of components in building |
| Variables | $X_{i,E}$ | Binary decision variable identifying the choice associated with extraction method $E$ for component $i$ |
| | $S_i$ | Start time of activity $i$ corresponding to component $i$ |
| | $T$ | Total project duration |

Various constraints are applied to solve the optimization and are represented by equations 5-9:

$$\forall i \ \Sigma X_{i,E}=1 \ {}_3E=1 \qquad \text{(Equation 5)}$$

$$\forall (i,j) \in A, \ X_{i,3} \leq X_{j,1} \qquad \text{(Equation 6)}$$

$$\forall (i,j) \in B, \ X_{i,1} \leq X_{j,1} \qquad \text{(Equation 7)}$$

$$\forall \ i, E \ T = \max(S_i + D_{i,E} \times X_{i,E}) \qquad \text{(Equation 8)}$$

$$\forall \ i,j, E \ S_j \geq p_{i,j,E} \times (S_i + D_{i,E} \times X_{i,E}) \qquad \text{(Equation 9)}$$

Equation 5 limits the extraction method to one choice for each component.

Equations 6 and 7 are used for components which are mutually exclusive but are connected. Equation 6 ensures that if a window is deconstructed the supporting wall is also deconstructed or demolished. Equation 7 ensures that if a floor is demolished the exterior walls of that floor are also demolished. Any other similar constraints can be added as other equations.

Equation 8 calculates the total project duration.

Equation 9 is used to limit the precedence and activity sequences of components in order to limit the start time of activities to the correct order of sequence.

Demolition and deconstruction follow different precedence and activity sequences. To address the two different possibilities an $n$ x $n$ matrix is made for each, where n is the number of components in the building. Each floor of the building is treated as one scheduled activity duration as demolition/deconstruction occurs from the top down by floor (e.g., a component on a lower floor can only be demolished once all floors above have been completed).

The sequence of demolition/deconstruction can be broken down further than floor by floor. The sequence usually followed is doors, interior walls, compound ceilings, and then windows, leaving all exterior components. Then the roof, exterior walls, columns and beams, and floors. The last step is to remove the foundation of the building.

Once the matrices for demolition and deconstruction have been generated, they are added to the optimization model as an additional constraint.

At Stage 3 1830, a sensitivity analysis can be performed to validate results and to analyze the capabilities of the optimization framework. Various sensitivity analyses can be employed including a Monte Carlo analysis, a One at a Time (OAT) analysis, an All Combinations Scenario analysis, and a Future Scenario analysis. Any number of sensitivity analyses may be applied to the results of the linear programming optimization. The analysis may be applied to all of the results or to only a few chosen scenarios.

Conventional methodologies for salvage estimation are not as comprehensive as the methodology of Figure 18. The methodology 1800 provides automated data set generation after initial input of building materials, precedence constraints, more complexity of building recovery factor and conditions, and deconstruction sequence planning.

In the proposed methodology, initially the building is broken down into its components based on the building model input. The availability of the materials for recovery are then assessed according to the type of materials, durability, and quality of the materials. Additionally, for each component the corresponding cost of demolition and deconstruction, salvage and scrap value, duration of demolition and deconstruction activities, and the environmental impact associated with landfilling, recycling, and reuse are estimated. The generation of this data is automated using the available inhouse databases on project costs, market values, and previously completed projects. In the next step, the generated dataset is fed into the optimization model which maximizes project cost and obtainable salvage value considering the feasibility of component extraction from the building. The feasibility is modeled based on the precedence of the extraction activities, connection between components in the building, and the possibility to effectively extract the component based on the size and potential to reach the component. The results of the analysis indicate the optimal end of life choice for the components whether to landfill, recycle, or reuse.

Figure 19 is a view of an example of a case study existing building to which the methodology of Figure 18 is applied, according to one embodiment. Figure 19 shows a BIM model 1910 of the building and an extracted section 1920 of the building to which the methodology was applied.

In the embodiment of Figure 19, IBM CPLEX optimization software was used to generate the optimization algorithm for the mixed-integer multi-objective linear program.

In the embodiment of Figure 19, the data collected for the building included: collecting materials takeoffs from the BIM model, building age, building material, component lifespan, and appropriate recoverability factors from the literature. Material extraction time and costs were estimated as Sigma estimates using RSMeans data. Landfill fees were determined from local landfill websites. Environment impact (EI) associated with each component were calculated with OneClick LCA. Salvage and scrap values were collected from marketplaces on the internet.

Figure 20 shows example graphs 2010 and 2020 representing component end-of-lifes for a cost optimized scenario (graph 2010) and a time optimized scenario (graph 2020) according to the methodology of Figure 18, for the building shown in Figure 19.

The materials shown in both graphs are ceiling, structural column, door, floor, roof, exterior wall, foundation wall, interior wall, and window.

For the cost-optimal scenario, different components require different EoL alternatives. Ceiling is the only material for which deconstruction would minimize cost. Structural columns, floor, roof, exterior wall, and foundation wall could minimize costs by demolition and recycling. Door, interior wall, and window show that within the component category there are materials that should be demolished and materials that should be deconstructed to minimize cost. Cost is not minimized for any component if that component were to be demolished and sent to a landfill.

For the time-optimal scenario, every component should be demolished and disposed of in a landfill to minimize the total time needed.

However, graphs 2010 and 2020 only show some of the components of the building. In actuality there were 167 components, of which, for the cost-optimal scenario, 86 should be demolished and recycled and 81 should be reused. For the time-optimal scenario all 167 components should be demolished and sent to a landfill.

Figure 21 shows an example graph 2100 representing the cost breakdown as it varies by project duration according to the methodology of Figure 18, according to one embodiment. In Figure 20, the only scenarios discussed were the cost-optimal scenario and the time-optimal scenario. However, when considering other factors such as EI, the decision maker(s) may choose to go with an intermediate approach. Graph 2100 shows how costs are affected by altering the time constraint.

Three project durations of 32 hours (time-optimal scenario), 35 hours, and 40 hours are shown in graph 2100. Each bar includes the demolition and deconstruction costs, landfill fees, sorting costs, transportation costs, and salvage benefits (including EI costs). As the duration of the project increases the demolition and deconstruction fees increase but other costs like landfill fees decrease. The overall result of increasing the duration is that the net cost decreases due to increased material terminal values and decreased EI costs.

Figure 22 shows example graphs 2210, 2220, 2230, and 2240 representing Monte Carlo sensitivity analysis results according to the methodology of Figure 18, according to one embodiment.

Multiple sensitivity analyses were performed for the case study including a Monte Carlo analysis, an OAT analysis, an All Combinations Scenario analysis, and a Future Scenarios analysis. However, only the Monte Carlo analysis is discussed herein.

The Monte Carlo analysis found that there is an 80 percent chance that net cost is lower than -$2500 and a fifty percent chance that net cost is lower than -$9400, which an 85 percent chance that a profit would be made from resale of the recovered materials. These values were calculated with internalized EI costs. If EI costs are externalized the net costs would be higher.

Graph 2210 shows the net cost of the project with the 85 percent chance that the owner will profit from the project.

Graph 2220 shows the obtainable value from the scrap and salvage materials with a 50 percent chance that a value of $47,000 can be obtained.

Graph 2230 shows that there is an eighty percent chance that at least 70 components could be recycled.

Graph 2240 shows that there is an 80 percent chance that at least 81 components could be reused.

Figure 23 is a flow diagram overview of a comprehensive workflow 2300a for building adaptation of an existing building which includes the methodologies of Figures 2A-2D, Figures 6A-6D, and Figure 18, according to one embodiment. The methodology of Figures 2A-2D is Methodology 1. The methodology of Figures 6A-6D is Methodology 2 (although methodology 2 can also be applied for new construction, here it is being used for an existing building). The methodology of Figure 18 is Methodology 3.

The workflow 2300a starts with an existing building 2302 which either needs to be adapted or demolished.

If the stakeholders/decision makers want the building to be adapted the workflow moves to step 2304 wherein Methodology 1, the interactive adaptation strategy decision process using IMO, is used to determine possible adaptation strategies for the building.

If an adaptation which lends itself to modularity is included in any of the optimal design scenarios found by Methodology 1 then the workflow can proceed to step 2306 wherein Methodology 2, generating modular design scenarios, is used to determine optimal designs for adaptation of the building using modules. From step 2306 the workflow proceeds to step 2308, identifying desired demolition.

If modularity is not included in any of the optimal design scenarios, the workflow can proceed directly from step 2304 to step 2308, identifying required demolition.

At step 2308, the demolition or deconstruction for performing the generated optimal design scenarios is identified.

At step 2310, Methodology 3, in-situ building material value estimation, is used to determine what the best EoL strategy is for the identified demolition requirements. The EoL options may be, as discussed above, demolition and landfill, demolition and recycling, or deconstruction and reuse.

As mentioned above, the in-situ material estimation algorithm can be applied to new construction projects as an indicator of the circularity of the construction project. Strategies including use of mono-material systems, recoverable envelope systems, use of detachable connections, and modular systems are modelled into the optimization algorithm. The impact of implementing the strategies on increasing the future material recovery and circularity of the building are assessed based on the outputs of the optimization algorithm. Each strategy impacts the outputs of the optimization depending on the effect of the strategy on the recovery of the building components, the precedence of the components, and the required effort in terms of labor and use of machinery in extracting building components. The final optimal solution identifies the most suitable strategy or combinations of strategies for a specific new construction building that can satisfy the various financial and environmental objectives of building owner and other involved stakeholders.

At step 2312, the optimal design scenarios generated by the use of methodologies 1 and 3 or 1, 2, and 3 are determined based on cost, energy use, daylighting, carbon saving, waste saving, environmental impact, etc. The decision makers can choose what the most important metrics are or factors in the decision of which design scenario is optimal in a given scenario.

Returning to the existing building 2302, if the stakeholders/decision makers want the building to be demolished the workflow goes straight to step 2314 wherein Methodology 3, in-situ building material value estimation, is used to determine the best EoL strategy for the components of the building based on time, costs, EI, etc.

At step 2316, the optimal EoL strategy for each building component is output along with the expected costs/profits, carbon saving, waste savings, EI, project duration, etc.

Additionally in some embodiments the stakeholders/decision makers may be unsure of whether adaptation or demolition/deconstruction should be performed. In those embodiments, both arms of the workflow, Methodology 1 and 3 and possibly 2 and just Methodology 3, determine the optimal way forward based on the factors which are most important to the stakeholders/decision makers.

Figure 23B is a flow diagram overview of a comprehensive methodology 2300B for a new building project which includes the methodologies of Figures 2A-2D, Figures 6A-6D, and Figure 18, according to one embodiment. The workflow of methodology 2300B is the same as methodology 2300A except that the scenarios and salvage estimations are being generated for a new building project which does not exist yet rather than an existing building.

The workflow 2300b starts with a building project 2302B which has not been fully designed yet. Various parameters or limitations of what the building should or can be are input into the process of methodology 2300B instead of the parameters of an existing building.

At step 2304b, Methodology 1, the interactive adaptation strategy decision process using IMO, is used to determine possible design strategies for the building.

If design scenarios which lend themselves to modularity are included in any of the optimal design scenarios found by Methodology 1 then the workflow can proceed to step 2306b wherein Methodology 2, generating modular design scenarios, is used to determine optimal designs for the building using modules. From step 2306b the workflow proceeds to step 2310b.

If modularity is not included in any of the optimal design scenarios, the workflow can proceed directly from step 2304b to step 2310b, identifying required demolition.

At step 2310b, Methodology 3, in-situ building material value estimation, is used to determine what the best EoL strategy is for the materials which will be used in the optimal design scenarios from step 2304b or 2306b. The EoL options may be, as discussed above, demolition and landfill, demolition and recycling, or deconstruction and reuse. Using in-situ building material value estimation before the building is even built allows for optimization over the lifetime of the building and for increased circularity.

At step 2312, the optimal design scenarios generated by the use of methodologies 1 and 3 or 1, 2, and 3 are determined based on cost, energy use, daylighting, carbon saving, waste saving, environmental impact, etc. The decision makers can choose what the most important metrics are or factors in the decision of which design scenario is optimal in a given scenario.

As discussed above, the automatic generation of design scenarios by the methodologies and algorithms of the workflow enables many more design scenarios to be analyzed than if only a few or even several design scenarios were generated by a designer or architect. No conventional methodology allows for generation of designs and analysis of design within a loop as the methodologies herein do. Real-time generation and analysis of the design scenarios within one system is computationally complex but still takes less time than the conventional process of design and consultation.

The simulations of design scenarios inherently contain complex and dependent equations where solving said equations requires high computational power. Automating input intake and enabling simulation of thousands of scenarios with no required manual interventions is significantly more efficient than traditional consulting approaches but does still require significant computation power.

Machine learning can be applied to the process to decrease the number of design options that are generated as the generation algorithm learns that certain design scenarios are rarely or never optimal. Additionally, through training the algorithms using previously completed projects, surrogate models can be developed that will substantially improve computational speed.

Figure 24 shows a simplified block diagram of components of a device 2400, such as a mobile device or portable electronic device. The device 2400 may be for example any of the devices shown or discussed in Figure 1. The device 2400 includes multiple components such as a processor 2402 that controls the operations of the device 2400. Communication functions, including data communications, voice communications, or both may be performed through a communication subsystem 2404. Data received by the device 2400 may be decompressed and decrypted by a decoder 2406. The communication subsystem 2404 may receive messages from and send messages to a wireless network 2450.

The wireless network 2450 may be any type of wireless network, including, but not limited to, data-centric wireless networks, voice-centric wireless networks, and dual-mode networks that support both voice and data communications.

The device 2400 may be a battery-powered device and as shown includes a battery interface 2442 for receiving one or more rechargeable batteries 2444.

The processor 2402 also interacts with additional subsystems such as a Random Access Memory (RAM) 2408, a flash memory 2410, a display 2412 (e.g. with a touch-sensitive overlay 2414 connected to an electronic controller 2416 that together comprise a touch-sensitive display 2418), an actuator assembly 2420, one or more optional force sensors 2422, an auxiliary input/output (I/O) subsystem 2424, a data port 2426, a speaker 2428, a microphone 2430, short-range communications systems 2432 and other device subsystems 2434.

In some embodiments, user-interaction with the graphical user interface may be performed through the touch-sensitive overlay 2414. The processor 2402 may interact with the touch-sensitive overlay 2414 via the electronic controller 2416. Information, such as text, characters, symbols, images, icons, and other items that may be displayed or rendered on a portable electronic device generated by the processor 2402 may be displayed on the touch-sensitive display 2418.

The processor 2402 may also interact with an accelerometer 2436 as shown in Figure 24. The accelerometer 2436 may be utilized for detecting direction of gravitational forces or gravity-induced reaction forces.

To identify a subscriber for network access according to the present embodiment, the device 2400 may use a Subscriber Identity Module or a Removable User Identity Module (SIM/RUIM) card 2438 inserted into a SIM/RUIM interface 2440 for communication with a network (such as the wireless network 2450). Alternatively, user identification information may be programmed into the flash memory 2410 or performed using other techniques.

The device 2400 also includes an operating system 2446 and software components 2448 that are executed by the processor 2402 and which may be stored in a persistent data storage device such as the flash memory 2410. Additional applications may be loaded onto the device 2400 through the wireless network 2450, the auxiliary I/O subsystem 2424, the data port 2426, the short-range communications subsystem 2432, or any other suitable device subsystem 2434.

For example, in use, a received signal such as a text message, an e-mail message, web page download, or other data may be processed by the communication subsystem 2404 and input to the processor 2402. The processor 2402 then processes the received signal for output to the display 2412 or alternatively to the auxiliary I/O subsystem 2424. A subscriber may also compose data items, such as e-mail messages, for example, which may be transmitted over the wireless network 2450 through the communication subsystem 2404.

For voice communications, the overall operation of the portable electronic device 2400 may be similar. The speaker 2428 may output audible information converted from electrical signals, and the microphone 2430 may convert audible information into electrical signals for processing.

While the above description provides examples of one or more apparatus, methods, or systems, it will be appreciated that other apparatus, methods, or systems may be within the scope of the claims as interpreted by one of skill in the art.

**Claims**

1. A computer-implemented method of building project circularity optimization for new construction, building adaptions, the method comprising:

   selecting a plurality of building strategies from a list of building strategies;
   inputting building information including an initial building geometry, wherein the initial building geometry is one of a geometry of an existing building and a geometry of a future building;
   generating a building model using the at least one selected building strategy and the building information;
   generating simulations of a plurality of design scenarios based on the building model;
   analyzing the plurality of design scenarios for a plurality of building metrics to determine at least one optimal design scenario by:

      analyzing the plurality of design scenarios by multi-objective optimization methods;
      analyzing the salvage estimation of the design scenarios by:

         calculating recoverable building materials of the design scenarios by:

            inputting building materials;
            generating material takeoff;
            generating cost, value, and environmental impact datasets; and
            generating a precedence matrix;

         wherein: performing an optimization wherein:

            i) a first salvage objective is optimized and a second salvage objective is calculated, wherein the first salvage objective is time and the second salvage objective is costs,
            ii) the second salvage objective is optimized and a first salvage objective is calculated,
            iii) a project first salvage objective-second salvage objective tradeoff curve is generated;

      analyzing each building material for end of life (EoL) possibilities using the optimization, wherein the EOL possibilities include i) demolition and disposal, ii) demolition, sorting and recycling, and iii) deconstruction and reuse;

      performing at least one sensitivity analysis to validate the EoL possibilities and to analyze an optimization framework; and
      outputting a circularity and salvage potential for the at least one optimal design scenario.

2. The method of claim 1 wherein the design scenarios include modular designs and the method further comprises:

parametrizing the building information into a plurality of building parameters;
inputting building requirements;
developing design constraints based on the building parameters, the building requirements, and the building model by:

creating a grid of the initial building geometry;
determining possible module characteristics;
determining parameters of module assemblies; and
determining and correcting any spatial adjacencies;

wherein generating simulations of a plurality of design scenarios further includes generating simulations of a plurality of design scenarios from an algorithm developed using the building information, the building requirements, the design constraints, and the building model.

3. The method of any one of claims 1 to 2 wherein the plurality of building strategies includes at least two of restructuring, recladding, insulating, relocating, layering, extending glazing, enclosing, adding, insetting, and extending.

4. The method of any one of claims 1 to 3 wherein generating simulations of each design scenario includes simulating energy use and daylighting of each scenario.

5. The method of any one of claims 1 to 4 further comprising calculating a life cycle analysis and a life cycle costing for each assembly determined during development of the design constraints.

6. The method of claim 5 further comprising calculating a total life cycle analysis and life cycle costing for each design scenario using the life cycle analyses and life cycles costings for each assembly.

7. The method of any one of claims 1 to 6 further comprising setting performance constraints and filtering design scenarios using the performance constraints.

8. The method of any one of claims 1 to 7 wherein the at least one optimal design scenario is selected based on life cycle costing and structural complexity.

9. A system for building project circularity optimization for new construction, building adaptions, the system comprising

at least one processor;
a non-transitory storage medium, storing processor executable instructions,
wherein the at least one processor executes the instructions to:

select a plurality of building strategies from a list of building strategies;
input building information including an initial building geometry, wherein the initial building geometry is one of a geometry of an existing building and a geometry of a future building;
generate a building model using the at least one selected building strategy and the building information;
generate simulations of a plurality of design scenarios based on the building model;

analyze the plurality of design scenarios to determine at least one optimal design scenario by:
analyzing the plurality of design scenarios by multi-objective optimization methods;
analyzing the salvage estimation of the design scenarios by:

calculating recoverable building materials of the design scenarios by:

inputting building materials;
generating material takeoff;
generating cost, value, and environmental impact datasets; and
generating a precedence matrix;

wherein: performing an optimization wherein:

i) a first salvage objective is optimized and a second salvage objective is calculated, wherein the first salvage objective is time and the second salvage objective is cost,
ii) the second salvage objective is optimized and a first salvage objective is calculated,
iii) a project first salvage objective-second salvage objective tradeoff curve is generated;

analyzing each building material for end of life (EoL) possibilities using the optimization, wherein the EOL possibilities include i) demolition and disposal, ii) demolition, sorting, and recycling, and iii) deconstruction and reuse;
perform a sensitivity analysis to validate the EoL possibilities and to analyze an optimization framework; and
output a circularity and salvage potential for the at least one optimal design scenario.

10. The system of claim 9 wherein the design scenarios include modular designs and the at least one processor further executes the instructions to:

parametrize the building information into a plurality of building parameters; input building requirements;
develop design constraints based on the building parameters, the building requirements, and the building model by:

create a grid of the initial building geometry;
determine possible module characteristics;
determine parameters of module assemblies; and
determine and correcting any spatial adjacencies;

wherein generating simulations of a plurality of design scenarios further includes generating simulations of a plurality of design scenarios from an algorithm developed using the building information, the building requirements, the design constraints, and the building model.

11. The method of claim 1 wherein the sensitivity analysis is chosen from a group consisting of: a Monte Carlo analysis, a One at a Time (OAT) analysis, an All Combinations analysis, and a Future Scenario analysis.

**Patentansprüche**

1. Computergestütztes Verfahren zur Optimierung der Zirkularität von Bauprojekten für Neubauten und Gebäudeanpassungen, wobei das Verfahren umfasst:

Auswählen einer Vielzahl von Gebäudestrategien aus einer Liste von Gebäudestrategien;
Eingeben von Gebäudeinformationen, einschließlich einer anfänglichen Gebäudegeometrie, wobei die anfängliche Gebäudegeometrie entweder die Geometrie eines bestehenden Gebäudes oder die Geometrie eines zukünftigen Gebäudes ist;
Erzeugen eines Gebäudemodells unter Verwendung der wenigstens einen ausgewählten Gebäudestrategie und der Gebäudeinformationen;
Erzeugen von Simulationen einer Vielzahl von Entwurfsszenarien auf der Grundlage des Gebäudemodells;
Analysieren der Vielzahl von Entwurfsszenarien hinsichtlich einer Vielzahl von Gebäudemetriken, um mindestens ein optimales Entwurfsszenario zu bestimmen durch:

Analyse der Vielzahl von Entwurfsszenarien durch multikriterielle Optimierungsmethoden;
Analyse der Verwertbarkeitsschätzung der Entwurfsszenarien durch:

Berechnen der wiederverwertbaren Baumaterialien der Entwurfsszenarien durch:

Eingeben von Baumaterialien;
Erstellen einer Materialaufstellung;
Erstellen von Datensätzen zu Kosten, Wert und Umweltauswirkungen; und
Erstellen einer Präzedenzmatrix;

mit: Durchführen einer Optimierung, wobei:

i) ein erstes Verwertungsziel optimiert und ein zweites Verwertungsziel berechnet wird, wobei das erste Verwertungsziel die Zeit und das zweite Verwertungsziel die Kosten sind,
ii) das zweite Verwertungsziel optimiert und ein erstes Verwertungsziel berechnet wird,
iii) eine Kompromisskurve zwischen dem ersten und dem zweiten Verwertungsziel eines Projekts erstellt wird;

Analysieren jedes Baumaterials hinsichtlich seiner Möglichkeiten am Ende der Lebensdauer (EoL) unter Verwendung der Optimierung, wobei die EoL-Möglichkeiten i) Abriss und Entsorgung, ii) Abriss, Sortierung und Recycling und iii) Rückbau und Wiederverwendung umfassen;

Durchführen mindestens einer Sensitivitätsanalyse zur Validierung der EoL-Möglichkeiten und zur Analyse eines Optimierungsrahmens; und
Ausgabe eines Zirkularitäts- und Verwertungspotenzials für das wenigstens eine optimale Entwurfsszenario.

2. Verfahren nach Anspruch 1, wobei die Entwurfsszenarien modulare Entwürfe umfassen und das Verfahren ferner umfasst:

Parametrisieren der Gebäudeinformationen in eine Vielzahl von Gebäudeparametern;
Eingeben von Gebäudeanforderungen;
Entwickeln von Entwurfsbeschränkungen auf der Grundlage der Gebäudeparameter, der Gebäudeanforderungen und des Gebäudemodells durch:

Erstellen eines Rasters der ursprünglichen Gebäudegeometrie;
Bestimmen möglicher Modulmerkmale;
Bestimmen der Parameter der Modulbaugruppen; und
Bestimmen und Korrektur etwaiger räumlicher Nachbarschaften;

wobei das Erzeugen von Simulationen aus einer Vielzahl von Entwurfsszenarien ferner das Erzeugen von Simulationen aus einer Vielzahl von Entwurfsszenarien aus einem Algorithmus umfasst, der unter Verwendung der Gebäudeinformationen, der Gebäudeanforderungen, der Entwurfsbeschränkungen und des Gebäudemodells entwickelt wurde.

3. Verfahren nach einem der Ansprüche 1 bis 2, wobei die Vielzahl von Gebäudestrategien mindestens zwei der folgenden umfasst: Umstrukturierung, Neuverkleidung, Isolierung, Verlegung, Schichtung, Erweiterung der Verglasung, Umschließung, Hinzufügung, Einfügung und Erweiterung.

4. Verfahren nach einem der Ansprüche 1 bis 3, wobei das Erzeugen von Simulationen jedes Entwurfsszenarios das Simulieren des Energieverbrauchs und der Tageslichtbeleuchtung jedes Szenarios umfasst.

5. Verfahren nach einem der Ansprüche 1 bis 4, das ferner das Berechnen einer Lebenszyklusanalyse und einer Lebenszykluskostenberechnung für jede Baugruppe umfasst, die während der Entwicklung der Designbeschränkungen bestimmt wurde.

6. Verfahren nach Anspruch 5, das ferner die Berechnung einer Gesamtlebenszyklusanalyse und einer Lebenszykluskostenberechnung für jedes Entwurfsszenario unter Verwendung der Lebenszyklusanalysen und Lebenszykluskostenberechnungen für jede Baugruppe umfasst.

7. Verfahren nach einem der Ansprüche 1 bis 6, das ferner das Festlegen von Leistungsbeschränkungen und das Filtern von Entwurfsszenarien unter Verwendung der Leistungsbeschränkungen umfasst.

8. Verfahren nach einem der Ansprüche 1 bis 7, wobei das mindestens eine optimale Designszenario auf der Grundlage der Lebenszykluskosten und der strukturellen Komplexität ausgewählt wird.

9. System zur Optimierung der Zirkularität von Bauprojekten für Neubauten und Gebäudeanpassungen, wobei das System umfasst:

mindestens einen Prozessor;
ein nichtflüchtiges Speichermedium, das vom Prozessor ausführbare Befehle speichert, wobei der mindestens eine Prozessor die Befehle ausführt, um:

eine Vielzahl von Gebäudestrategien aus einer Liste von Gebäudestrategien auszuwählen;
Gebäudeinformationen einschließlich einer anfänglichen Gebäudegeometrie einzugeben, wobei die anfängliche Gebäudegeometrie entweder eine Geometrie eines bestehenden Gebäudes oder eine Geometrie eines zukünftigen Gebäudes ist;
ein Gebäudemodell unter Verwendung der mindestens einen ausgewählten Gebäudestrategie und der Gebäudeinformationen zu generieren;
Simulationen einer Vielzahl von Entwurfsszenarien auf der Grundlage des Gebäudemodells zu erzeugen;

die Vielzahl von Entwurfsszenarien zu analysieren, um mindestens ein optimales Entwurfsszenario zu bestimmen, indem:
Analyse der Vielzahl von Entwurfsszenarien durch multikriterielle Optimierungsmethoden;
Analyse der Verwertbarkeitsschätzung der Entwurfsszenarien durch:

Berechnen der wiederverwertbaren Baumaterialien der Entwurfsszenarien durch:

Eingeben von Baumaterialien;
Erstellen einer Materialaufstellung;
Erstellen von Datensätzen zu Kosten, Wert und Umweltauswirkungen; und
Erstellen einer Präzedenzmatrix;

wobei: eine Optimierung durchgeführt wird, wobei:

i) ein erstes Bergungsziel optimiert und ein zweites Bergungsziel berechnet wird, wobei das erste Bergungsziel die Zeit und das zweite Bergungsziel die Kosten sind,
ii) das zweite Bergungsziel optimiert und ein erstes Bergungsziel berechnet wird,
iii) eine Kompromisskurve zwischen dem ersten und dem zweiten Bergungsziel eines Projekts erstellt wird;

jedes Baumaterial hinsichtlich seiner Möglichkeiten am Ende der Lebensdauer (EoL) unter Verwendung der Optimierung analysiert wird, wobei die EoL-Möglichkeiten i) Abriss und Entsorgung, ii) Abriss, Sortierung und Recycling und iii) Rückbau und Wiederverwendung umfassen;
Durchführen einer Sensitivitätsanalyse zur Validierung der EoL-Möglichkeiten und zur Analyse eines Optimierungsrahmens; und
Ausgeben einer Zirkularität und eines Verwertungspotenzials für das mindestens eine optimale Entwurfsszenario.

10. System nach Anspruch 9, wobei die Entwurfsszenarien modulare Entwürfe umfassen und der mindestens eine Prozessor die Anweisungen weiter ausführt, um:

die Gebäudeinformationen in eine Vielzahl von Gebäudeparametern zu parametrisieren;
Gebäudeanforderungen einzugeben;
Entwickeln von Designbeschränkungen auf der Grundlage der Gebäudeparameter, der Gebäudeanforderungen und des Gebäudemodells durch:

Erstellen eines Rasters der ursprünglichen Gebäudegeometrie;
Bestimmen möglicher Moduleigenschaften;
Festlegen der Parameter der Modulbaugruppen; und
Bestimmen und Korrektur etwaiger räumlicher Nachbarschaften;

wobei das Erzeugen von Simulationen einer Vielzahl von Entwurfsszenarien ferner das Erzeugen von Simulationen einer Vielzahl von Entwurfsszenarien aus einem Algorithmus umfasst, der unter Verwendung der Gebäudeinformationen, der Gebäudeanforderungen, der Entwurfsbeschränkungen und des Gebäudemodells entwickelt wurde.

11. Verfahren nach Anspruch 11, wobei die Sensitivitätsanalyse aus einer Gruppe ausgewählt wird, die aus einer Monte-Carlo-Analyse, einer One-at-a-Time-Analyse (OAT), einer All-Combinations-Analyse und einer Future-Scenario-Analyse besteht.

**Revendications**

1.  Procédé informatique d'optimisation de la circularité des projets de construction pour les nouvelles constructions et les adaptations de bâtiments, le procédé comprenant :

    la sélection d'une pluralité de stratégies de construction à partir d'une liste de stratégies de construction ;
    la saisie d'informations de construction, y compris une géométrie initiale du bâtiment, la géométrie initiale du bâtiment étant soit la géométrie d'un bâtiment existant, soit la géométrie d'un futur bâtiment ;
    générer un modèle de bâtiment à l'aide d'au moins une stratégie de construction sélectionnée et des informations de construction ;
    générer des simulations d'une pluralité de scénarios de conception sur la base du modèle de bâtiment ;
    analyser la pluralité de scénarios de conception pour une pluralité de mesures de construction afin de déterminer au moins un scénario de conception optimal en :

    analysant la pluralité de scénarios de conception à l'aide de méthodes d'optimisation multi-objectifs ;
    analysant l'estimation de récupération des scénarios de conception en :

    calculant les matériaux de construction récupérables des scénarios de conception en :

    saisissant les matériaux de construction ;
    générant le métré des matériaux ;
    générant des ensembles de données sur les coûts, la valeur et l'impact environnemental ; et
    générant une matrice de priorité ;

    dans lequel : réalisation d'une optimisation dans laquelle :

    i) un premier objectif de récupération est optimisé et un deuxième objectif de récupération est calculé, le premier objectif de récupération étant le temps et le deuxième objectif de récupération étant les coûts,
    ii) le deuxième objectif de récupération est optimisé et un premier objectif de récupération est calculé,
    iii) une courbe de compromis entre le premier objectif de récupération et le deuxième objectif de récupération du projet est générée ;

    analyser chaque matériau de construction pour déterminer les possibilités de fin de vie (EoL) à l'aide de l'optimisation, les possibilités EOL comprenant i) la démolition et l'élimination, ii) la démolition, le tri et le recyclage, et iii) la déconstruction et la réutilisation ;

    réaliser au moins une analyse de sensibilité pour valider les possibilités de fin de vie et analyser un cadre d'optimisation ; et
    générer une circularité et un potentiel de récupération pour le au moins un scénario de conception optimal.

2.  Procédé selon la revendication 1, dans lequel les scénarios de conception comprennent des conceptions modulaires et le procédé comprend en outre :

    la paramétrisation des informations du bâtiment en une pluralité de paramètres de bâtiment ;
    la saisie des exigences du bâtiment ;
    développer des contraintes de conception basées sur les paramètres du bâtiment, les exigences du bâtiment et le modèle du bâtiment en :

    créant une grille de la géométrie initiale du bâtiment ;
    déterminant les caractéristiques possibles des modules ;
    déterminant les paramètres des assemblages de modules ; et
    déterminant et corrigeant toute adjacence spatiale ;

dans lequel la génération de simulations d'une pluralité de scénarios de conception comprend en outre la génération de simulations d'une pluralité de scénarios de conception à partir d'un algorithme développé à l'aide des informations du bâtiment, des exigences du bâtiment, des contraintes de conception et du modèle du bâtiment.

3. Procédé selon l'une quelconque des revendications 1 à 2, dans lequel la pluralité de stratégies de bâtiment comprend au moins deux des stratégies suivantes : restructuration, recouvrement, isolation, déplacement, superposition, extension du vitrage, fermeture, ajout, encastrement et extension.

4. Procédé selon l'une quelconque des revendications 1 à 3, dans lequel la génération de simulations de chaque scénario de conception comprend la simulation de la consommation d'énergie et de l'éclairage naturel de chaque scénario.

5. Procédé selon l'une quelconque des revendications 1 à 4, comprenant en outre le calcul d'une analyse du cycle de vie et d'un coût du cycle de vie pour chaque assemblage déterminé lors de l'élaboration des contraintes de conception.

6. Procédé selon la revendication 5, comprenant en outre le calcul d'une analyse du cycle de vie total et d'un coût du cycle de vie pour chaque scénario de conception à l'aide des analyses du cycle de vie et des coûts du cycle de vie pour chaque assemblage.

7. Procédé selon l'une quelconque des revendications 1 à 6, comprenant en outre la définition de contraintes de performance et le filtrage des scénarios de conception à l'aide des contraintes de performance.

8. Procédé selon l'une quelconque des revendications 1 à 7, dans lequel le au moins un scénario de conception optimal est sélectionné sur la base du coût du cycle de vie et de la complexité structurelle.

9. Système d'optimisation de la circularité des projets de construction pour les nouvelles constructions et les adaptations de bâtiments, le système comprenant :

   au moins un processeur ;
   un support de stockage non transitoire, stockant des instructions exécutables par le processeur, dans lequel le au moins un processeur exécute les instructions pour :

      sélectionner une pluralité de stratégies de construction à partir d'une liste de stratégies de construction ;
      saisir des informations de construction, y compris une géométrie initiale du bâtiment, dans lequel la géométrie initiale du bâtiment est l'une parmi une géométrie d'un bâtiment existant et une géométrie d'un futur bâtiment ;
      générer un modèle de bâtiment à l'aide de la au moins une stratégie de construction sélectionnée et des informations de construction ;
      générer des simulations d'une pluralité de scénarios de conception sur la base du modèle de construction ;

   analyser la pluralité de scénarios de conception afin de déterminer au moins un scénario de conception optimal en :
   analysant la pluralité de scénarios de conception à l'aide de méthodes d'optimisation multi-objectifs ;
   analysant l'estimation de récupération des scénarios de conception en :

      calculant les matériaux de construction récupérables des scénarios de conception en :

         saisissant les matériaux de construction ;
         générant le métré des matériaux ;
         générant des ensembles de données sur les coûts, la valeur et l'impact environnemental ; et
         générant une matrice de priorité ;

      dans lequel : on effectue une optimisation dans laquelle :

         i) un premier objectif de récupération est optimisé et un deuxième objectif de récupération est calculé, dans lequel le premier objectif de récupération est le temps et le deuxième objectif de récupération est le coût,

ii) le deuxième objectif de récupération est optimisé et un premier objectif de récupération est calculé,
iii) une courbe de compromis entre le premier objectif de récupération et le deuxième objectif de récupération du projet est générée ;

analyser chaque matériau de construction pour déterminer les possibilités de fin de vie (EoL) à l'aide de l'optimisation, les possibilités EOL comprenant i) la démolition et l'élimination, ii) la démolition, le tri et le recyclage, et iii) la déconstruction et la réutilisation ;
réaliser une analyse de sensibilité pour valider les possibilités de fin de vie et analyser un cadre d'optimisation ; et
générer un potentiel de circularité et de récupération pour au moins un scénario de conception optimal.

**10.** Système selon la revendication 9, dans lequel les scénarios de conception comprennent des conceptions modulaires et le au moins un processeur exécute en outre les instructions pour :

paramétrer les informations du bâtiment en une pluralité de paramètres de bâtiment ;
saisir les exigences du bâtiment ;
développer des contraintes de conception basées sur les paramètres du bâtiment, les exigences du bâtiment et le modèle du bâtiment en :

créer une grille de la géométrie initiale du bâtiment ;
déterminer les caractéristiques possibles des modules ;
déterminant les paramètres des assemblages de modules ; et
déterminant et corrigeant toute adjacence spatiale ;

dans lequel la génération de simulations d'une pluralité de scénarios de conception comprend en outre la génération de simulations d'une pluralité de scénarios de conception à partir d'un algorithme développé à l'aide des informations du bâtiment, des exigences du bâtiment, des contraintes de conception et du modèle du bâtiment.

**11.** Procédé selon la revendication 11, dans lequel l'analyse de sensibilité est choisie parmi un groupe comprenant : une analyse Monte Carlo, une analyse One at a Time (OAT), une analyse All Combinations et une analyse Future Scenario.

100

110 Requirement Input

105 Building Input

115 Design Input & Analysis

120 Consultants

125 Suitable Design Options

FIG. 1 – Prior Art

200a

210

220

230

Stage 1: Building Design Option Selection and Model Preparation

Stage 2: Design Option Simulation

Stage 3: Result Analysis

FIG. 2A

200b

212

214

Identify Building
Adaptation
Strategies

BIM Model of
Adaptation
Strategies on
Building System

FIG. 2B

FIG. 2C

FIG. 5

300

302

304

306

308

310

312

314

316

318

320

322

FIG. 3

EP 4 468 219 B1

FIG. 4

33

FIG. 5

600a

610

620

630

Stage 1:
Analysis and
Parametrization of
Existing Building

Stage 2: Option
Generation and
Simulation

Stage 3: Result
Refinement and
Optimization

FIG. 6A

600b

611

Requirement
Input

Design Constraint
Development:

1. Grid
2. Module
3. Assemblies
4. Spatial Adjacencies

614

612

Building Input

Calculate LCA/LCC of
Assemblies

615

Building Analysis

613

FIG. 6B

600c

**Stage 1**

Design Constraint
Development:

1. Grid
2. Module
3. Assemblies
4. Spatial Adjacencies

Calculate LCA/LCC of
Assemblies

621

Algorithm
Development:

Generation of
Design options

622

Simulate, Analyze,
and Filter Design
Options:

Simulate Energy
and Daylighting

Examine Structural
Requirements

Compute Total
LCA/LCC

FIG. 6C

FIG. 6D

FIG. 7

FIG. 8

FIG. 9

FIG. 10

1110  1112  1114  1116

FIG. 11

1210    1220

Multiple horizontal surfaces
Single horizontal surface

Multiple vertical surfaces
Single vertical surface

FIG. 12

1310

1320

interior floor
soffit

interior floor
Terrace

FIG. 13

1410

1420

Energy Use

Daylighting

**Attributes**

count: permutation 117
numberOfModules: 49
numberOfModule Types: 16
minNumPanelTypes: 3
maxNumPanelTypes: 5
udli100_2000 (%): 41.037
sDA (%): 48.9
energyUse (kWh/yr): 178.537
Embodied Carbon (kgCO2): 120420.58
normalizedStrScore: 1.265
Total LCA (kgCO2e): 11839.649
Total LCC ($/m2): 4144.635

Energy Use (kWh/m²)

253.6< 229.3 205.1 180.8 156.6 132.3 108.0 83.8 59.5 35.3 <10.9

Spatial Daylight Autonomy (sDA) (%)

70< 66 62 58 54 50 46 42 38 34 <30

FIG. 14

FIG. 15a

FIG. 15b

FIG. 16

Existing Structure

New Modules

FIG. 17

1810

1820

1830

Stage 1:
Calculate
Available
Materials

Stage 2: Linear
Program
Optimization

Stage 3:
Sensitivity
Analysis

FIG. 18

1910

1920

FIG. 19

FIG. 20

FIG. 21

a- Cost (not including EI costs)

b- Obtainable Value

c- Recycled Components

d- Reused Components

FIG. 22

2302A

2300A

Existing Building

2304

Adaptation – Use
Methodology 1:
Interactive Adaptation
Strategy Decision Process

2306

Modularity - Use
Methodology 2:
Generating Modular
Design Options

2314

Demolition- Use
Methodology 3: Salvage
Value Estimation

2308

Identify Required
Demolition

2316

Output: optimal cost, value,
carbon saving, waste
savings, EoL for each
building component

2310

Methodology 3 – Salvage
Value Estimation

2312

Output: optimal design
options based on cost,
energy, carbon saving,
waste saving, etc.

FIG. 23A

2300b

New Construction — 2302b

2304b

Adaptation – Use
Methodology 1: Interactive
Adaptation Strategy
Decision Process

Modularity - Use
Methodology 2: Generating
Modular Design Options — 2306b

2310b Methodology 3 – In situ
building material value
estimation

2312b Output: optimal design options based
on cost, energy, carbon saving, waste
saving, EoL for each builing
component, etc.

FIG. 23B

**2400**

FIG. 24

**EP 4 468 219 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010235206 A1
- US 2020380179 A1
- US 2013325410 A1
- US 2022374802 A1